# EUROPEAN PATENT APPLICATION

(11) **EP 4 447 112 A2**
(43) Date of publication of application: **16.10.2024**
(21) Application number: 24164440.0
(22) Date of filing: 19.03.2024
(51) Int. Cl.: H01L 27/12, H01L 29/786

(54) **DISPLAY APPARATUS**

(30) Priority: 24.03.2023 KR 20230039037; 29.03.2023 KR 20230041537
(71) Applicant: Samsung Display Co., Ltd., Yongin-si, Gyeonggi-do 17113 (KR)
(72) Inventor: Cho, Youngjin, 17113 Giheung-gu, Yongin-si, Gyeonggi-do (KR); Cho, Seungyeon, 17113 Giheung-gu, Yongin-si, Gyeonggi-do (KR)
(74) Representative: Dr. Weitzel & Partner

(57) **Abstract**

A display apparatus includes: a substrate; a first scan line on the substrate and extending in a first direction; a semiconductor layer on the substrate, and comprising a first drain region, a first source region extending in the first direction so that at least a portion of the first source region overlaps the first scan line, and a driving active region between the first drain region and the first source region; a first gate electrode on the semiconductor layer and overlapping the driving active region; a second gate electrode under the semiconductor layer and overlapping the driving active region; and a first node connection line on the first gate electrode, electrically connected to the first gate electrode, and extending in a second direction that intersects the first direction.

## Description

### BACKGROUND

### 1. Field

The present invention relates to a display apparatus.

### 2. Description of the Related Art

Recently, display apparatuses have been used for various purposes. Also, as thicknesses and weights of display apparatuses have decreased, the range of applications of display apparatuses has increased.

In a display apparatus, thin-film transistors, capacitors, and wirings may be located in each pixel to control a luminance, etc. of each pixel. As display apparatuses are being used in various ways, various types of display apparatuses are being designed.

The above information disclosed in this Background section is only for enhancement of understanding of the background and therefore the information discussed in this Background section does not necessarily constitute prior art.

### SUMMARY

The present invention provides a display apparatus configured to display relatively high-quality images. The present invention is defined by the features of the independent claims. The embodiments disclosed herein are examples, and do not limit the scope of the invention.

Additional aspects will be set forth in part in the description which follows and, in part, will be apparent from the description, or may be learned by practice of the presented embodiments.

According to one or more embodiments, a display apparatus includes a substrate, a first scan line located on the substrate and extending in a first direction, a semiconductor layer located on the substrate, and including a first drain region, a first source region extending in the first direction so that at least a portion of the first source region overlaps the first scan line, and a driving active region located between the first drain region and the first source region, a first gate electrode located on the semiconductor layer and overlapping the driving active region, a second gate electrode located under the semiconductor layer and overlapping the driving active region, and a first node connection line located on the first gate electrode, electrically connected to the first gate electrode, and extending in a second direction that intersects the first direction.

According to some embodiments, in a plan view, a portion of the first source region may overlap an area where the first scan line and the first node connection line intersect each other.

According to some embodiments, the display apparatus may further include a storage capacitor including a first capacitor electrode integrally provided with the first gate electrode and a second capacitor electrode integrally provided with the second gate electrode.

According to some embodiments, the second capacitor electrode may be electrically connected to the first source region.

According to some embodiments, the storage capacitor may further include a third capacitor electrode located on the substrate and a fourth capacitor electrode located between the third capacitor electrode and the second capacitor electrode, wherein the first capacitor electrode is electrically connected to the fourth capacitor electrode, and the second capacitor electrode is electrically connected to the third capacitor electrode.

According to some embodiments, the storage capacitor may further include a fifth capacitor electrode located between the third capacitor electrode and the fourth capacitor electrode and electrically connected to the fourth capacitor electrode.

According to some embodiments, the display apparatus may further include a hold capacitor including a first hold capacitor electrode integrally provided with the third capacitor electrode and a second hold capacitor electrode located on the first hold capacitor electrode and electrically connected to a first driving voltage line.

According to some embodiments, the hold capacitor may further include a third hold capacitor electrode located on the second hold capacitor electrode and electrically connected to the first hold capacitor electrode and a fourth hold capacitor electrode located on the third hold capacitor electrode and electrically connected to the second hold capacitor electrode.

According to some embodiments, the hold capacitor may further include a fifth hold capacitor electrode located on the fourth hold capacitor electrode and electrically connected to the first source region.

According to some embodiments, the second gate electrode may include a protrusion overlapping an area where the first scan line and the first node connection line intersect each other in a plan view.

According to some embodiments, the semiconductor layer may include an oxide semiconductor material.

According to some embodiments, the display apparatus may further include a second driving voltage line extending in the second direction, located on the first node connection line, and defining a hole overlapping the first node connection line.

According to one or more embodiments, a display apparatus includes a substrate, a first scan line located on the substrate and extending in a first direction, a semiconductor layer located on the substrate, and including a first drain region, a first source region, and a driving active region located between the first drain region and the first source region, a first gate electrode located on the semiconductor layer and overlapping the driving active region, a second gate electrode located under the semiconductor layer and overlapping the driving active region, and a first node connection line located on the first gate electrode, electrically connected to the first gate electrode, and extending in a second direction that intersects the first direction, wherein the second gate electrode includes a protrusion overlapping an area where the first scan line and the first node connection line intersect each other in a plan view.

According to some embodiments, the display apparatus may further include a storage capacitor including a first capacitor electrode integrally provided with the first gate electrode and a second capacitor electrode integrally provided with the second gate electrode.

According to some embodiments, the second capacitor electrode may be electrically connected to the first source region.

According to some embodiments, the storage capacitor may further include a third capacitor electrode located on the substrate and a fourth capacitor electrode located between the third capacitor electrode and the second capacitor electrode, wherein the first capacitor electrode is electrically connected to the fourth capacitor electrode, and the second capacitor electrode is electrically connected to the third capacitor electrode.

According to some embodiments, the display apparatus may further include a hold capacitor including a first hold capacitor electrode integrally provided with the third capacitor electrode and a second hold capacitor electrode located on the first hold capacitor electrode and electrically connected to a first driving voltage line.

According to some embodiments, the hold capacitor may further include a third hold capacitor electrode located on the second hold capacitor electrode and electrically connected to the first hold capacitor electrode and a fourth hold capacitor electrode located on the third hold capacitor electrode and electrically connected to the second hold capacitor electrode.

According to some embodiments, the semiconductor layer may include an oxide semiconductor material.

According to some embodiments, the display apparatus may further include a second driving voltage line extending in the second direction, located on the first node connection line, and defining a hole overlapping the first node connection line.

Other aspects, features, and characteristics of some embodiments of the present invention will become more apparent from the drawings, the claims, and the detailed description.

### BRIEF DESCRIPTION OF THE DRAWINGS

The above and other aspects, features, and characteristics of certain embodiments will be more apparent from the following description taken in conjunction with the accompanying drawings, in which:
FIG. 1 is a plan view schematically illustrating a display apparatus, according to some embodiments of the present invention;
FIG. 2 is an equivalent circuit diagram schematically illustrating a pixel included in a display apparatus, according to some embodiments of the present invention;
FIG. 3 is a view schematically illustrating an arrangement of a portion A of the display apparatus of FIG. 1 according to some embodiments of the present invention;
FIGS. 4 to 12 are views schematically illustrating an arrangement of the portion A of the display apparatus of FIG. 1 for each layer according to some embodiments of the present invention;
FIG. 13 is an enlarged view schematically illustrating an arrangement of a portion of a display apparatus, according to some embodiments of the present invention;
FIG. 14 is a cross-sectional view schematically illustrating the display apparatus of FIG. 13, taken along a line B-B' according to some embodiments of the present invention;
FIG. 15 is a view schematically illustrating an arrangement of a portion of a second conductive layer of a display apparatus, according to some embodiments of the present invention;
FIG. 16 is a cross-sectional view schematically illustrating a portion of the display apparatus of FIG. 15 according to some embodiments of the present invention, FIG. 16 being taken along a cross-sectional line of FIG. 15 similar to a line B-B' of FIG. 13;
FIGS. 17A to 18B are cross-sectional views illustrating a structure of an organic light-emitting diode included in a display apparatus, according to some embodiments of the present invention; and
FIG. 19 is a cross-sectional view illustrating structures of organic light-emitting diodes included in a display apparatus, according to some embodiments of the present invention.

### DETAILED DESCRIPTION

Reference will now be made in more detail to aspects of some embodiments, which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or any combination of a, b, and/or c.

As the invention allows for various changes and numerous embodiments, certain embodiments will be illustrated in the drawings and described in the detailed description. Effects and features of the invention, and methods for achieving them will be clarified with reference to embodiments described below in detail with reference to the drawings. However, the invention is not limited to the following embodiments and may be embodied in various forms.

Hereinafter, aspects of some embodiments will be described in more detail with reference to the accompanying drawings, wherein the same or corresponding elements are denoted by the same reference numerals throughout and a repeated description thereof is omitted.

While terms such as "first," "second," etc., may be used to describe various components, such components are not be limited to the above terms. The above terms are used only to distinguish one component from another.

The singular forms "a," "an," and "the" as used herein are intended to include the plural forms as well unless the context clearly indicates differently.

It will be understood that the terms "including," and "having," are intended to indicate the existence of the features or elements described in the specification, and are not intended to preclude the possibility that one or more other features or elements may exist or may be added.

It will be further understood that, when a layer, region, or component is referred to as being "on" another layer, region, or component, it may be directly on the other layer, region, or component, or may be indirectly on the other layer, region, or component with intervening layers, regions, or components therebetween.

In the specification, it will be understood that when a layer, an area, or a component is referred to as being "connected" to another layer, area, or component, it may be "directly connected" to the other layer, area, or component and/or may be "indirectly connected" to the other layer, area, or component with other layers, areas, or components interposed therebetween. For example, when a layer, an area, or a component is referred to as being "electrically connected," it may be directly electrically connected, and/or may be indirectly electrically connected with intervening layers, areas, or components therebetween.

"A and/or B" is used herein to select only A, select only B, or select both A and B. "At least one of A and B" is used to select only A, select only B, or select both A and B.

In the following embodiments, the x-axis (the x-axis direction), the y-axis (the y-axis direction) and the z-axis (the z-axis direction) are not limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment may be implemented differently, a specific process order may be different from the described order. For example, two consecutively described processes may be performed substantially at the same time or may be performed in an order opposite to the described order.

Sizes of components in the drawings may be exaggerated or reduced for convenience of explanation. For example, because sizes and thicknesses of elements in the drawings are arbitrarily illustrated for convenience of explanation, the invention is not limited thereto.

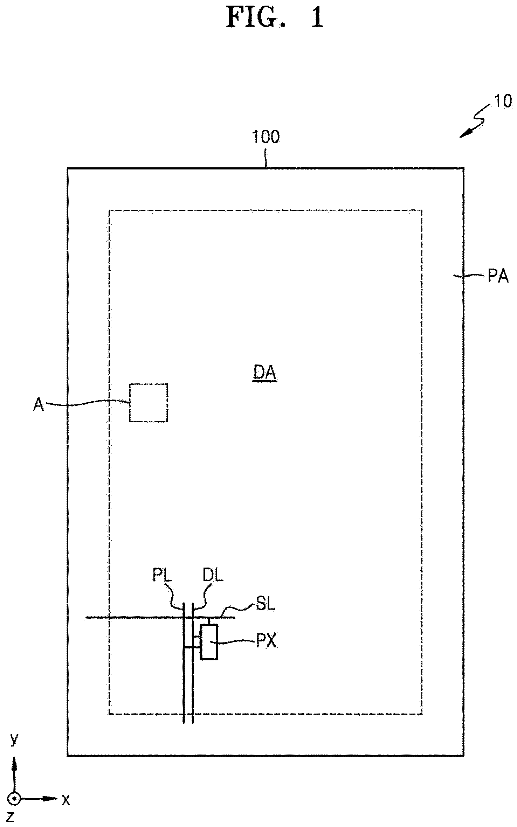

FIG. 1 is a plan view schematically illustrating a display apparatus, according to some embodiments of the present invention.

Referring to FIG. 1, a display apparatus according to some embodiments may include a display panel 10. The display apparatus may be any apparatus including the display panel 10. For example, the display apparatus may be any of various apparatuses such as a smartphone, a tablet, a laptop, a television, or a billboard.

The display apparatus according to some embodiments includes thin-film transistors and a capacitor, and the thin-film transistors and the capacitor may be implemented by semiconductor layers, conductive layers and insulating layers included in the display panel 10.

The display panel 10 includes a display area DA and a peripheral area PA located outside (e.g., in a periphery or outside a footprint of) the display area DA. Because the display panel 10 includes a substrate 100, the substrate 100 may include portions corresponding to the display area DA and the peripheral area PA.

The substrate 100 may include a glass material, a ceramic material, or a metal material. The substrate 100 may include a flexible or bendable material. When the substrate 100 is flexible or bendable, the substrate 100 may include a polymer resin such as a polyethersulfone, polyacrylate, polyetherimide, polyethylene naphthalate, polyethylene terephthalate, polyphenylene sulfide, polyarylate, polyimide, polycarbonate, or cellulose acetate propionate.

The substrate 100 may have a single or multi-layer structure including the above material, and when the substrate 100 has a multi-layer structure, the substrate 100 may further include an inorganic layer.

In FIG. 1, the display area DA has a rectangular shape in which a width in a first direction (e.g., an x-axis direction) is less than a width in a second direction (e.g., a y-axis direction). However, embodiments according to the present invention are not limited thereto. The display area DA may have any of various shapes such as a circular shape, an elliptical shape, the other polygonal shape, or a specific shape. For example, the third direction (e.g., a z-axis direction) is perpendicular to a plane defined by the first direction (e.g., an x-axis direction) and the second direction (e.g., a y-axis direction).

The display area DA is a portion where images are displayed, and a plurality of pixels PX may be located in the display area DA. Each pixel PX may include a display element such as an organic light-emitting diode and a pixel circuit electrically connected to the display element. Each pixel PX may emit, for example, red light, green light, or blue light. The pixel PX may be connected to a pixel circuit including a thin-film transistor and a storage capacitor. The pixel circuit may be connected to a scan line SL through which a scan signal is transmitted, a data line DL that intersects the scan line SL and through which a data signal is transmitted, and a driving voltage line PL through which a driving voltage is supplied. The scan line SL may extend in the first direction (e.g., the x-axis direction), and the data line DL may extend in the second direction (e.g., the y-axis direction).

Although the driving voltage line PL extends in the second direction (e.g., the y-axis direction) in FIG. 1, this is merely an example, and the driving voltage line PL may include first driving voltage lines extending in the first direction (e.g., the x-axis direction) and second driving voltage lines extending in the second direction (e.g., the y-axis direction). The first driving voltage lines and the second driving voltage lines may intersect each other to form a mesh shape.

Each pixel PX may emit light in response to an electrical signal applied to the pixel circuit through the scan line SL, the data line DL, and the driving voltage line PL. Each of the scan lines SL may extend in the first direction (e.g., the x-axis direction) and may be connected to the pixels PX located in the same row. Each of the scan lines SL may transmit a scan signal to the pixels PX located in the same row. Each of the data lines DL may extend in the second direction (e.g., the y-axis direction) and may be connected to the pixels PX located in the same column. Each of the data lines DL may transmit a data signal to each of the pixels PX located in the same column in synchronization with the scan signal. The display area DA may display a certain image through light emitted from the pixel PX. For reference, the pixel PX may be defined as an emission area that emits light of any one of red, green, and blue colors.

Although the pixel PX is connected to one scan line SL in FIG. 1, this is merely an example, and one pixel PX may be connected to two or more scan lines SL, and a gate driving circuit may supply two or more scan signals having different timings at which an on voltage is applied to the scan lines.

The peripheral area PA may be a non-display area where the pixels PX are not located. Various wirings, a scan driving circuit, an emission control driving circuit, and pads for transmitting electrical signals to be applied to the display area DA may be located in the peripheral area PA. The scan driving circuit may provide a scan signal to the pixel PX through the scan line SL. The emission control driving circuit may provide an emission control signal to the pixel PX through an emission control line. The pads located in the peripheral area PA may be exposed without being covered by an insulating layer, and may be electrically connected to a printed circuit board or a driver IC chip.

Hereinafter, although an organic light-emitting display apparatus is described as a display apparatus according to some embodiments, the display apparatus of the invention is not limited thereto. According to some embodiments, the display apparatus may be an inorganic light-emitting display apparatus, an inorganic electroluminescent (EL) display apparatus, or a quantum dot light-emitting display apparatus. For example, an emission layer of a display element included in the display apparatus may include an organic material or an inorganic material. Also, the display apparatus may include an emission layer, and quantum dots located in a path of light emitted from the emission layer.

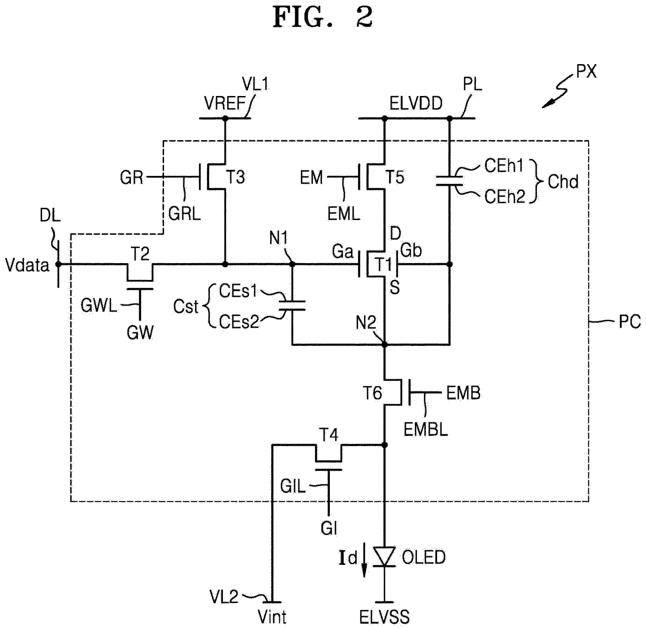

FIG. 2 is an equivalent circuit diagram schematically illustrating a pixel included in a display apparatus, according to some embodiments.

Referring to FIG. 2, the pixel PX may include the organic light-emitting diode OLED as a display element and the pixel circuit PC connected to the organic light-emitting diode OLED. The pixel circuit PC may include first to sixth transistors T1 to T6, and first a storage capacitor Cst and a hold capacitor Chd. The first transistor T1 may be a driving transistor that outputs driving current corresponding to a data signal, and the second to sixth transistors T2 to T6 may be switching transistors that transmit signals. A first terminal (first electrode) of each of the first to sixth transistors T1 to T6 may be a source or a drain, and a second terminal (second electrode) may be a terminal different from the first terminal. For example, when the first terminal is a drain, the second terminal may be a source.

The pixel PX may be connected to a first scan line GWL that transmits a first scan signal GW, a second scan line GIL that transmits a second scan signal GI, a third scan line GRL that transmits a third scan signal GR, a first emission control line EML that transmits a first emission control signal EM, a second emission control line EMBL that transmits a second emission control signal EMB, and a data line DL that transmits a data signal Vdata. Also, the pixel PX may be connected to a driving voltage line PL that transmits a driving voltage ELVDD, a first voltage line VL1 that transmits a reference voltage VREF, and a second voltage line VL2 that transmits an initialization voltage Vint.

The first transistor T1 may be connected between the driving voltage line PL and a second node N2. The first transistor T1 may include a gate, the first terminal, and the second terminal connected to the second node N2. The first terminal may be a drain D and the second terminal may be a source S. The gate of the first transistor T1 may include a first gate electrode Ga connected to a first node N1, and a second gate electrode Gb connected to the second node N2. The first gate electrode Ga and the second gate electrode Gb may be located on different layers to face each other. For example, the first gate electrode Ga and the second gate electrode Gb of the first transistor T1 may face each other with a semiconductor layer therebetween. The first terminal of the first transistor T1 may be connected to the driving voltage line PL via the fifth transistor T5, and the second terminal may be connected to a pixel electrode of an organic light-emitting diode OLED. The first transistor T1 may receive the data signal Vdata according to a switching operation of the second transistor T2, and may control the amount of driving current Id flowing to the organic light-emitting diode OLED.

The second transistor T2 may be connected between the data line DL and the first node N1. The second transistor T2 may include a gate connected to the first scan line GWL, the first terminal connected to the data line DL, and the second terminal connected to the first node N1. The second transistor T2 may be turned on by the first scan signal GW transmitted through the first scan line GWL, to electrically connect the data line DL to the first node N1 and transmit the data signal Vdata transmitted through the data line DL to the first node N1.

The third transistor T3 may be connected between the first node N1 and the first voltage line VL1. The third transistor T3 may include a gate connected to the third scan line GRL, the first terminal connected to the first node N1, and the second terminal connected to the first voltage line VL1. The third transistor T3 may be turned on by the third scan signal GR transmitted through the third scan line GRL, to transmit the reference voltage VREF transmitted through the first voltage line VL1 to the first node N1.

The fourth transistor T4 may be connected between the first transistor T1 and the second voltage line VL2. The fourth transistor T4 may include a gate connected to the second scan line GIL, the first terminal connected to the second terminal of the sixth transistor T6 and the organic light-emitting diode OLED, and the second terminal connected to the second voltage line VL2. The fourth transistor T4 may be turned on by the second scan signal GI transmitted through the second scan line GIL, to transmit the initialization voltage Vint transmitted through the second voltage line VL2 to the pixel electrode of the organic light-emitting diode OLED.

The fifth transistor T5 may be connected between the driving voltage line PL and the first transistor T1. The fifth transistor T5 may include a gate connected to the first emission control line EML, the first terminal connected to the driving voltage line PL, and the second terminal connected to the first terminal of the first transistor T1. The fifth transistor T5 may be turned on or turned off according to the first emission control signal EM transmitted through the first emission control line EML.

The sixth transistor T6 may be connected between the first transistor T1 and the organic light-emitting diode OLED. The sixth transistor T6 may include a gate connected to the second emission control line EMBL, the first terminal connected to the second node N2, and the second terminal connected to the organic light-emitting diode OLED. The sixth transistor T6 may be turned on by the second emission control signal EMB transmitted through the second emission control line EMBL, to connect the second node N2 to the pixel electrode of the organic light-emitting diode OLED.

Although the fifth transistor T5 and the sixth transistor T6 operate in response to different emission control signals EM and EMB in FIG. 2, according to some embodiments, the fifth transistor T5 and the sixth transistor T6 may operate in response to the same emission control signal.

According to some embodiments, the third scan signal GR may be substantially synchronized with the first scan signal GW of the pixel PX located in a previous row. The second scan signal GI may be substantially synchronized with the first scan signal GW. According to some embodiments, the second scan signal GI may be substantially synchronized with the first scan signal GW or the third scan signal GR of the pixel PX located in a next row.

A storage capacitor Cst may be connected between the first node N1 and the second node N2. In other words, the pixel circuit PC included in the display apparatus according to some embodiments may be a source follower type circuit in which the storage capacitor Cst is connected between the first node N1 and the second node N2. A first electrode CEs1 of the storage capacitor Cst may be connected to the first node N1, and a second electrode CEs2 may be connected to the second node N2. The storage capacitor Cst may store a voltage corresponding to the data signal Vdata and a threshold voltage of the first transistor T1.

A hold capacitor Chd may be connected between the driving voltage line PL and the second node N2. A first electrode CEh1 of the hold capacitor Chd may be connected to the driving voltage line PL, and a second electrode CEh2 may be connected to the second node N2.

The organic light-emitting diode OLED may include the pixel electrode connected to the second node N2 via the sixth transistor T6 and a counter electrode facing the pixel electrode, and the counter electrode may receive a common voltage ELVSS. The counter electrode may be a common electrode common to a plurality of pixels PX.

Although the pixel circuit PC includes six transistors and two capacitors in FIG. 2, according to some embodiments, the pixel circuit PC may include five transistors and two capacitors. According to some embodiments, the pixel circuit PC may include seven transistors and two capacitors. Additionally, according to some embodiments, the pixel circuit PC may include additional components or fewer components.

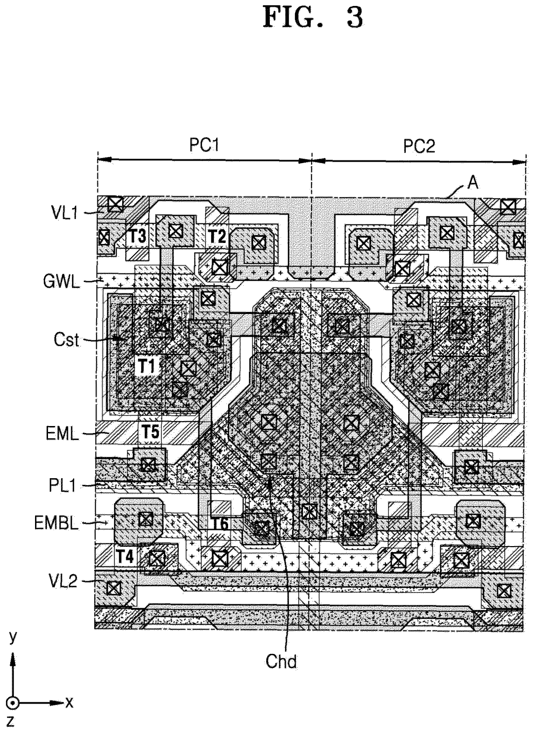

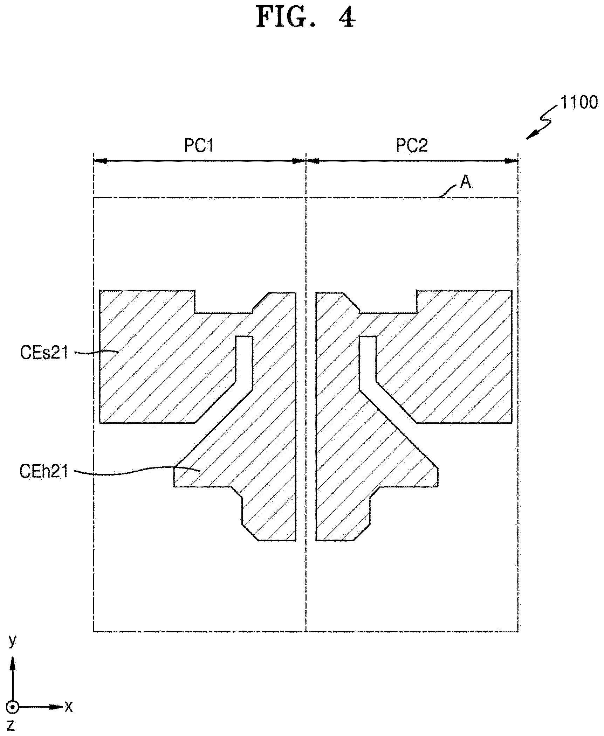

FIG. 3 is a view schematically illustrating an arrangement of a portion A of the display apparatus of FIG. 1. FIGS. 4 to 12 are views schematically illustrating an arrangement of the portion A of the display apparatus of FIG. 1 for each layer. In FIGS. 3 to 12, a first pixel circuit PC1 and a second pixel circuit PC2 adjacent to each other may have a line-symmetric structure about a center line. For convenience of explanation, the first pixel circuit PC1 will be mainly described, and the description may be substantially applied to the second pixel circuit PC2.

First, referring to FIG. 3, further referring to FIG. 2, FIGS 4 to 7, FIG. 9, and FIGS. 11 to 14, a display apparatus may include the first pixel circuit PC1 and the second pixel circuit PC2. The first pixel circuit PC1 and the second pixel circuit PC2 may be arranged in the first direction (e.g., the x-axis direction).

Each of the first pixel circuit PC1 and the second pixel circuit PC2 may correspond to the pixel circuit PC of FIG. 2. For example, each of the first pixel circuit PC1 and the second pixel circuit PC2 may include the first to sixth transistors T1 to T6, the storage capacitor Cst, and the hold capacitor Chd.

According to some embodiments, the first pixel circuit PC1 and the second pixel circuit PC2 may be electrically connected to display elements emitting light of different colors. For example, the first pixel circuit PC1 may be electrically connected to the organic light-emitting diode OLED (see FIG. 2) emitting light of a first color, and the second pixel circuit PC2 may be electrically connected to the organic light-emitting diode OLED (see FIG.2) emitting light of a second color.

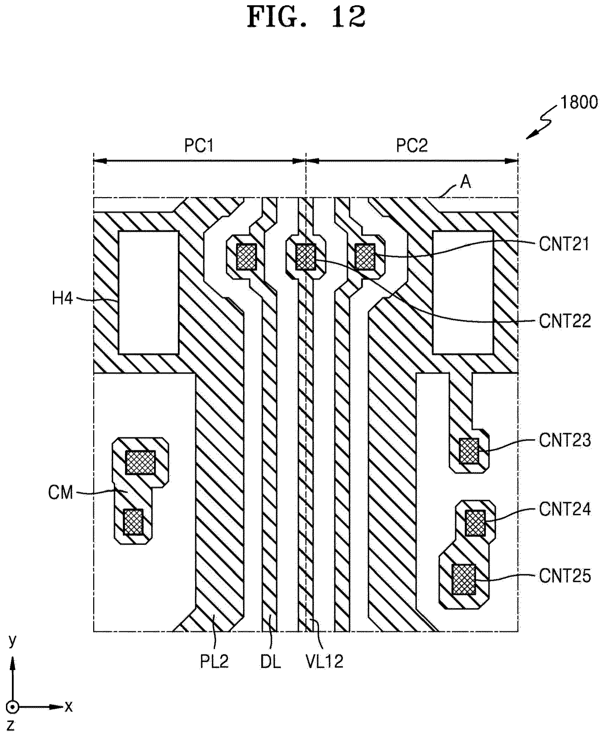

The first pixel circuit PC1 may be electrically connected to the first voltage line VL1, the first scan line GWL, the first emission control line EML, a first driving voltage line PL1, the second emission control line EMBL, and the second voltage line VL2. Although the driving voltage line PL is shown as a single line in FIG. 2, the driving voltage line PL may include the first driving voltage line PL1 and a second driving voltage line PL2 located on different conductive layers, wherein the first driving voltage line PL1 extends in the first direction (e.g., the x-axis direction) and the second driving voltage line PL2 (see FIG. 12) extends in the second direction (e.g., the y-axis direction). Likewise, although the first voltage line VL1 is shown as a single line in FIG. 2, the first voltage line VL1 may include a first sub-voltage line VL11 and a second sub-voltage line VL12 located on different conductive layers, wherein the first sub-voltage line VL11 extends in the first direction (e.g., the x-axis direction) and the second sub-voltage line VL12 extends in the second direction (e.g., the y-axis direction).

The first electrode CEs1 (see FIG. 2) of the storage capacitor Cst electrically connected to the first node N1 (see FIG. 2) may include at least one capacitor electrode located on different conductive layers. For example, the first electrode CEs1 of the storage capacitor Cst may include a first capacitor electrode CEs13, a fourth capacitor electrode CEs12, and a fifth capacitor electrode CEs11. The second electrode CEs2 of the storage capacitor Cst electrically connected to the second node N2 may include at least one capacitor electrode located on different conductive layers. For example, the second electrode CEs2 of the storage capacitor Cst may include a second capacitor electrode CEs22, a third capacitor electrode CEs21, and a sixth capacitor electrode CEs23. However, the invention is not limited thereto, and the number of capacitor electrodes may be changed. In a plan view, at least portions of capacitor electrodes of the storage capacitor Cst may overlap each other.

The first electrode CEh1 (see FIG. 2) of the hold capacitor Chd electrically connected to the driving voltage line PL (see FIG. 2) may include at least one hold capacitor electrode located on different conductive layers. For example, the first electrode CEh1 of the hold capacitor Chd may include a second hold capacitor electrode CEh11, a fourth hold capacitor electrode CEh13, and a sixth hold capacitor electrode CEh14. The second electrode CEh2 of the hold capacitor Chd electrically connected to the second node N2 (see FIG. 2) may include at least one hold capacitor electrode located on different conductive layers. For example, the second electrode CEh2 of the hold capacitor Chd may include a first hold capacitor electrode CEh21, a third hold capacitor electrode CEh22, and a fifth hold capacitor electrode CEh23. However, the invention is not limited thereto, and the number of hold capacitor electrodes may be changed. In a plan view, at least portions of hold capacitor electrodes of the hold capacitor Chd may overlap each other.

Elements such as transistors and a capacitor of the display apparatus of FIG. 3 will be described in more detail with reference to FIGS. 4 to 12.

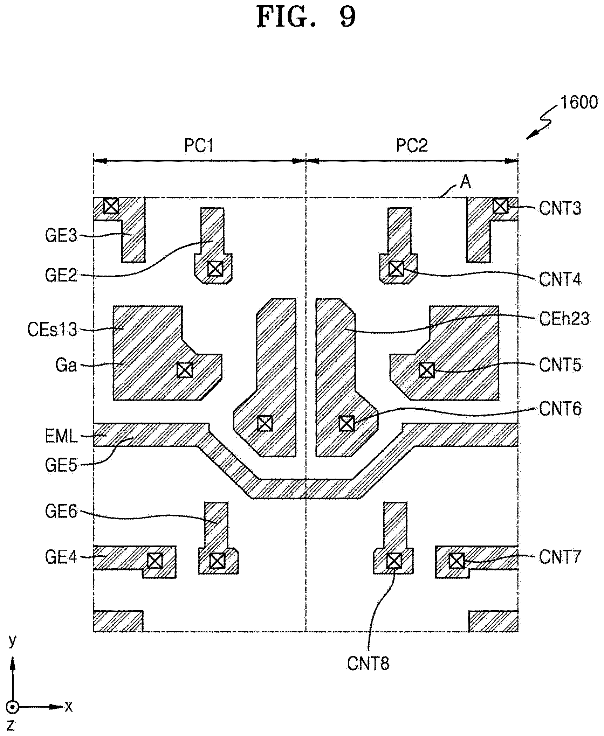

Referring to FIGS 4 to 7, further referring to FIGS. 9 to 11, a first lower metal layer 1100 of FIG. 4 may be located on the substrate 100 (see FIG. 1). The first lower metal layer 1100 may include molybdenum (Mo), aluminum (Al), copper (Cu), or titanium (Ti), and may have a single or multi-layer structure. For example, the first lower metal layer 1100 may have a single-layer structure including Mo.

The first lower metal layer 1100 may include the third capacitor electrode CEs21 and the first hold capacitor electrode CEh21. The third capacitor electrode CEs21 may be any one of capacitor electrodes corresponding to the second electrode CEs2 (see FIG. 2) of the storage capacitor Cst (see FIG. 2). The first hold capacitor electrode CEh21 may be any one of hold capacitor electrodes corresponding to the second electrode CEh2 (see FIG. 2) of the hold capacitor Chd (see FIG. 2).

The third capacitor electrode CEs21 may be electrically connected to the first hold capacitor electrode CEh21. For example, the third capacitor electrode CEs21 may be integrally provided (or integrally formed) with the first hold capacitor electrode CEh21.

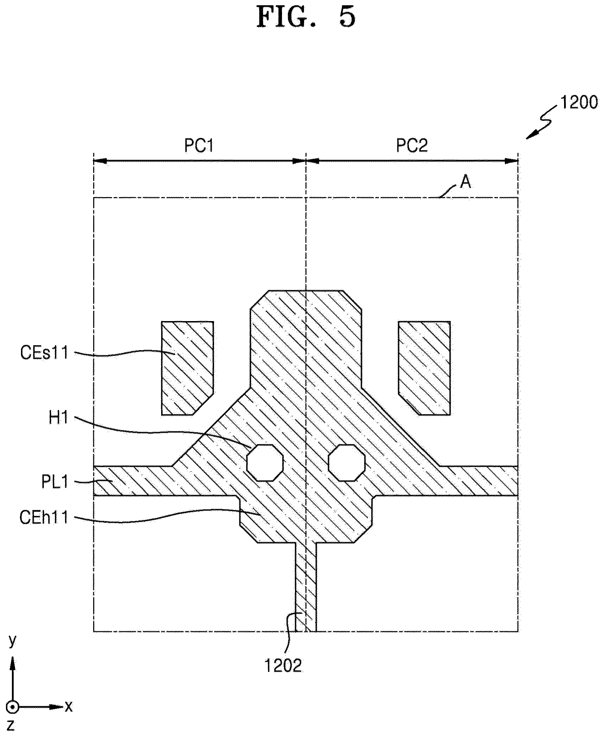

A second lower metal layer 1200 of FIG. 5 may be located on the first lower metal layer 1100. The second lower metal layer 1200 may include molybdenum (Mo), aluminum (Al), copper (Cu), or titanium (Ti), and may have a single or multi-layer structure. For example, the second lower metal layer 1200 may have a single-layer structure including Mo.

The second lower metal layer 1200 may include the fifth capacitor electrode CEs11, the second hold capacitor electrode CEh11, the first driving voltage line PL1, and a first connection wiring 1202.

The fifth capacitor electrode CEs11 may be any one of capacitor electrodes corresponding to the first electrode CEs1 (see FIG. 2) of the storage capacitor Cst. The fifth capacitor electrode CEs11 may be electrically connected to the fourth capacitor electrode CEs12 located over the fifth capacitor electrode CEs11 through a first contact portion CNT1.

The second hold capacitor electrode CEh11 may be any one of hold capacitor electrodes corresponding to the first electrode CEh1 (see FIG. 2) of the hold capacitor Chd. The second hold capacitor electrode CEh11 may define a first hole H1 passing through the second hold capacitor electrode CEh11. The third hold capacitor electrode CEh22 located over the second hold capacitor electrode CEh11 and the first hold capacitor electrode CEh21 located under the second hold capacitor electrode CEh11 may be electrically connected to each other through a second contact portion CNT2 overlapping the first hole H1. The second hold capacitor electrode CEh11 may be integrally provided with the first driving voltage line PL1.

The first driving voltage line PL1 may extend in the first direction (e.g., the x-axis direction), and may apply the driving voltage ELVDD (see FIG. 2) to the second hold capacitor electrode CEh11. As described above, the driving voltage line PL (see FIG. 2) may include the first driving voltage line PL1 extending in the first direction (e.g., the x-axis direction) and the second driving voltage line PL2 (see FIG. 12) extending in the second direction (e.g., the y-axis direction), and the first driving voltage line PL1 may intersect the second driving voltage line PL2 to form a mesh shape in an entire surface of the display area DA (see FIG. 1).

The second hold capacitor electrode CEh11 may be electrically connected to neighboring pixel circuits located in a next row through the first connection wiring 1202.

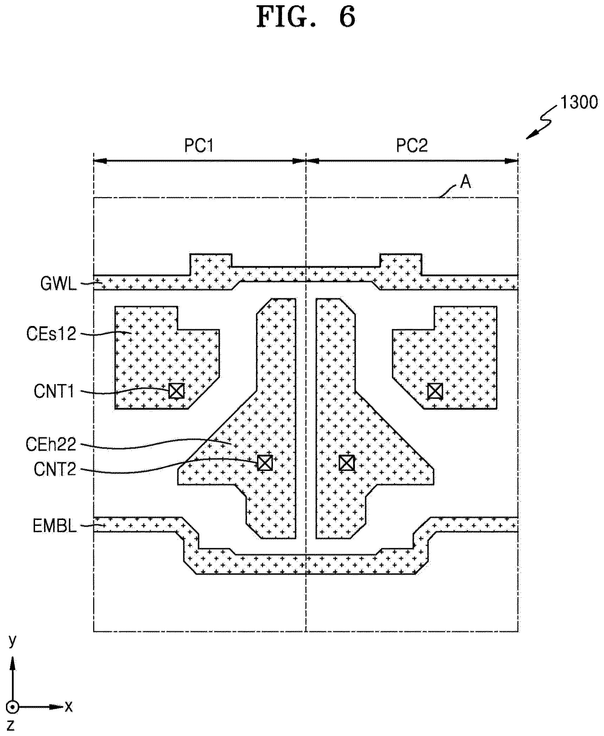

A first conductive layer 1300 of FIG. 6 may be located on the second lower metal layer 1200. The first conductive layer 1300 may include molybdenum (Mo), aluminum (Al), copper (Cu), or titanium (Ti), and may have a single or multi-layer structure.

The first conductive layer 1300 may include the first scan line GWL, the second emission control line EMBL, the fourth capacitor electrode CEs12, and the third hold capacitor electrode CEh22.

The first scan line GWL and the second emission control line EMBL may substantially extend in the first direction (e.g., the x-axis direction). The first scan line GWL may be electrically connected to a gate electrode GE2 of the second transistor T2 through a fourth contact portion CNT4. The first scan line GWL may transmit the first scan signal GW (see FIG. 2) to the gate electrode GE2 of the second transistor T2.

The second emission control line EMBL may be electrically connected to a gate electrode GE6 of the sixth transistor T6 through an eighth contact portion CNT8. The second emission control line EMBL may transmit the second emission control signal EMB (see FIG. 2) to the gate electrode GE6 of the sixth transistor T6.

The fourth capacitor electrode CEs12 may be any one of capacitor electrodes corresponding to the first electrode CEs1 (see FIG. 2) of the storage capacitor Cst. The fourth capacitor electrode CEs12 may be electrically connected to the fifth capacitor electrode CEs11 located under the fourth capacitor electrode CEs12 through the first contact portion CNT1.

The third hold capacitor electrode CEh22 may be any one of hold capacitor electrodes corresponding to the second electrode CEh2 (see FIG. 2) of the hold capacitor Chd. The third hold capacitor electrode CEh22 may be electrically connected to the first hold capacitor electrode CEh21 located under the second hold capacitor electrode CEh11, through the second contact portion CNT2 overlapping the first hole H1.

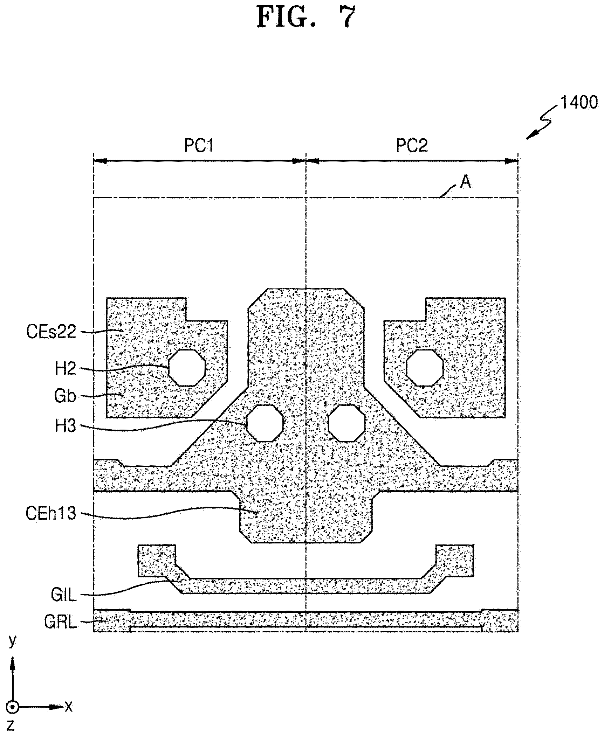

A second conductive layer 1400 of FIG. 7 may be located on the first conductive layer 1300. The second conductive layer 1400 may include molybdenum (Mo), aluminum (Al), copper (Cu), or titanium (Ti), and may have a single or multi-layer structure.

The second conductive layer 1400 may include the second scan line GIL, the third scan line GRL, the second capacitor electrode CEs22, and the fourth hold capacitor electrode CEh13.

The second scan line GIL and the third scan line GRL may substantially extend in the first direction (e.g., the x-axis direction). The second scan line GIL may be electrically connected to a gate electrode GE4 of the fourth transistor T4 through a seventh contact portion CNT7. The gate electrode GE4 of the fourth transistor T4 may be electrically connected to the second scan lines GIL of neighboring pixels located in the same row. The second scan line GIL may transmit the second scan signal GI (see FIG. 2) to the gate electrode GE4 of the fourth transistor T4.

The third scan line GRL may be electrically connected to a gate electrode GE3 of the third transistor T3 through a third contact portion CNT3. The third scan line GRL may transmit the third scan signal GR to the gate electrode GE3 of the third transistor T3.

The second capacitor electrode CEs22 may be any one of capacitor electrodes corresponding to the second electrode CEs2 (see FIG. 2) of the storage capacitor Cst. The second capacitor electrode CEs22 may function as the second gate electrode Gb located under a driving active region of the first transistor T1. In other words, the second capacitor electrode CEs22 and the second gate electrode Gb of the first transistor T1 may be integrally provided with each other. The second capacitor electrode CEs22 may be electrically connected to the sixth capacitor electrode CEs23 through a 14^{th} contact portion CNT14. The second capacitor electrode CEs22 may define a second hole H2 passing through the second capacitor electrode CEs22.

The fourth hold capacitor electrode CEh13 may be any one of hold capacitor electrodes corresponding to the first electrode CEh1 (see FIG. 2) of the hold capacitor Chd. The fourth hold capacitor electrodes CEh13 of pixels located in the same row may be electrically connected to each other. The fourth hold capacitor electrode CEh13 may define a third hole H3 passing through the fourth hold capacitor electrode CEh13.

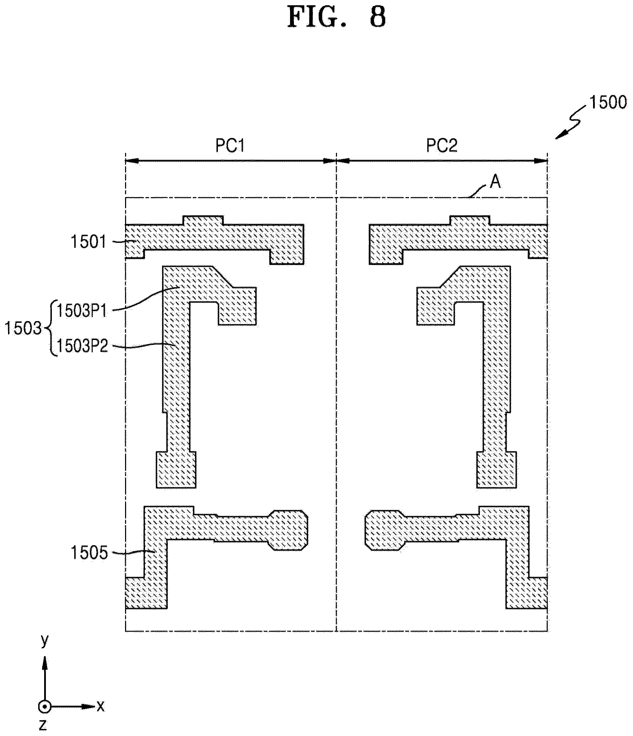

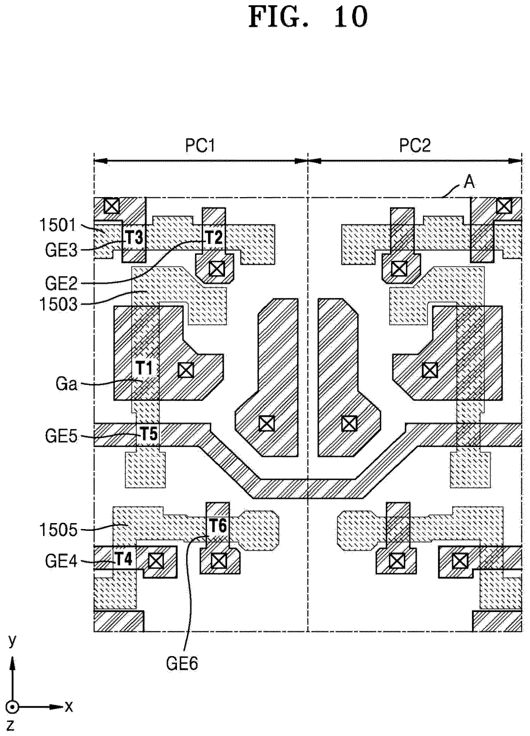

A semiconductor layer 1500 of FIG. 8 may be located on the second conductive layer 1400, and a third conductive layer 1600 of FIG. 9 may be located on the semiconductor layer 1500. For convenience of explanation, FIG. 10 is a view illustrating that the semiconductor layer 1500 of FIG. 8 and the third conductive layer 1600 of FIG. 9 overlap each other.

Referring to FIGS. 8 to 10, further referring to FIG. 2, the semiconductor layer 1500 may include an oxide of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). For example, the semiconductor layer 1500 may be an InSnZnO (ITZO) semiconductor layer or an InGaZnO (IGZO) semiconductor layer. When necessary, a conductive process by plasma treatment or the like may be performed on at least a portion of the semiconductor layer 1500.

The semiconductor layer 1500 may include a first semiconductor pattern 1501, a second semiconductor pattern 1503, and a third semiconductor pattern 1505 which are spaced apart from each other.

The third conductive layer 1600 may include molybdenum (Mo), aluminum (Al), copper (Cu), or titanium (Ti), and may have a single or multi-layer structure.

The third conductive layer 1600 may include the first emission control line EML, the first capacitor electrode CEs13, the fifth hold capacitor electrode CEh23, the gate electrode GE2 of the second transistor T2, the gate electrode GE3 of the third transistor T3, the gate electrode GE4 of the fourth transistor T4, and the gate electrode GE6 of the sixth transistor T6.

The first emission control line EML may substantially extend in the first direction (e.g., the x-axis direction). A portion of the first emission control line EML overlapping the second semiconductor pattern 1503 under the first emission control line EML may function as a gate electrode GE5 of the fifth transistor T5.

The first capacitor electrode CEs13 may be any one of capacitor electrodes corresponding to the first electrode CEs1 (see FIG. 2) of the storage capacitor Cst. The first capacitor electrode CEs13 may function as the first gate electrode Ga located on the driving active region of the first transistor T1. In other words, the first capacitor electrode CEs13 and the first gate electrode Ga of the first transistor T1 may be integrally provided with each other. The first capacitor electrode CEs13 may be electrically connected to the fourth capacitor electrode CEs12 (see FIG. 6) through a fifth contact portion CNT5 overlapping the second hole H2 (see FIG. 7).

The fifth hold capacitor electrode CEh23 may be any one of hold capacitor electrodes corresponding to the second electrode CEh2 (see FIG. 2) of the hold capacitor Chd. The fifth hold capacitor electrode CEh23 may be electrically connected to the third hold capacitor electrode CEh22 (see FIG. 6) through a sixth contact portion CNT6 overlapping the third hole H3 (see FIG. 7).

In a plan view, the gate electrode GE2 of the second transistor T2 and the gate electrode GE3 of the third transistor T3 may overlap the first semiconductor pattern 1501. The gate electrode GE2 of the second transistor T2 may be electrically connected to the first scan line GWL through the fourth contact portion CNT4. The gate electrode GE2 of the second transistor T2 may receive the first scan signal GW through the first scan line GWL (see FIG. 3). The gate electrode GE3 of the third transistor T3 may be electrically connected to the third scan line GRL (see FIG. 7) through the third contact portion CNT3. The gate electrode GE3 of the third transistor T3 may receive the third scan signal GR through the third scan line GRL.

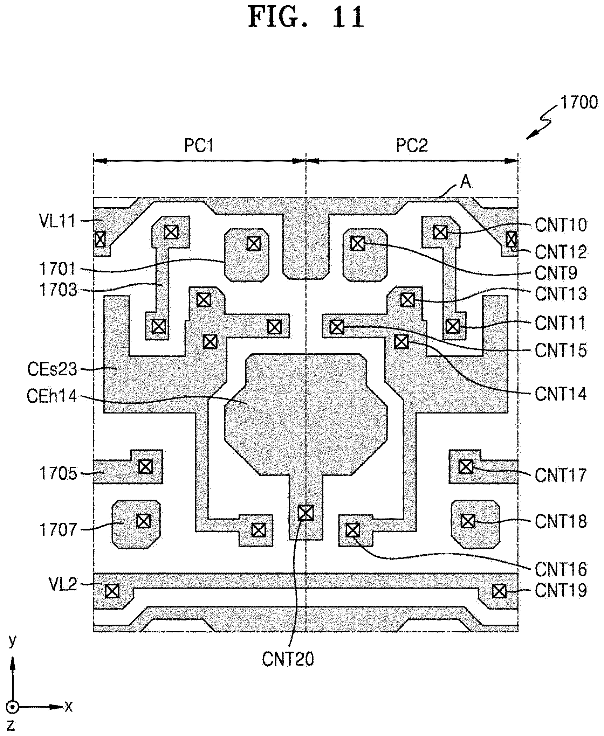

In a plan view, the first gate electrode Ga of the first transistor T1 and the gate electrode GE5 of the fifth transistor T5 may overlap the second semiconductor pattern 1503. The first gate electrode Ga of the first transistor T1 may be electrically connected to a first node connection line 1703 (see FIG. 11) described below through an 11^{th} contact portion CNT11 (see FIG. 11). Also, the first gate electrode Ga may be electrically connected to the fourth capacitor electrode CEs12 through the fifth contact portion CNT5 overlapping the second hole H2. The gate electrode GE5 of the fifth transistor T5 may receive the first emission control signal EM through the first emission control line EML.

In a plan view, the gate electrode GE4 of the fourth transistor T4 and the gate electrode GE6 of the sixth transistor T6 may overlap the third semiconductor pattern 1505. The gate electrode GE4 of the fourth transistor T4 may be electrically connected to the second scan line GIL through the seventh contact portion CNT7. The gate electrode GE4 of the fourth transistor T4 may receive the second scan signal GI through the second scan line GIL (see FIG. 7). The gate electrode GE6 of the sixth transistor T6 may be electrically connected to the second emission control line EMBL (see FIG. 3) through the eighth contact portion CNT8. The gate electrode GE6 of the sixth transistor T6 may receive the second emission control signal EMB through the second emission control line EMBL.

The second semiconductor pattern 1503 may be electrically connected to the sixth capacitor electrode CEs23 (see FIG. 11) through a 13^{th} contact portion CNT13 (see FIG. 11). A portion of the second semiconductor pattern 1503 electrically connected to the sixth capacitor electrode CEs23 corresponding to the second electrode CEs2 (see FIG. 2) of the storage capacitor Cst may function as a first source region of the first transistor T1. In other words, the second semiconductor pattern 1503 may include the first source region, a first drain region, and the driving active region located between the first source region and the first drain region of the first transistor T1. In a plan view, the driving active region of the first transistor T1 may overlap the first gate electrode Ga and the second gate electrode Gb (see FIG. 7).

At least a portion of the first source region of the first transistor T1 may extend in the same direction as an extending direction of the first scan line GWL to overlap the first scan line GWL. For example, the first source region of the first transistor T1 may include a first portion 1503P1 extending in the first direction (e.g., the x-axis direction) and a second portion 1503P2 bent and extending from the first portion 1503P1. According to some embodiments, the second portion 1503P2 of the second semiconductor pattern 1503 may extend in a direction (e.g., the second direction or the y-axis direction) perpendicular to an extending direction of the first portion 1503P1. The first portion 1503P1 of the second semiconductor pattern 1503 may have a width extended in the second direction (e.g., the y-axis direction) to sufficiently cover the first scan line GWL.

A fourth conductive layer 1700 of FIG. 11 may be located on the third conductive layer 1600 (see FIG. 9). The fourth conductive layer 1700 may include a conductive material including molybdenum (Mo), aluminum (Al), copper (Cu), or titanium (Ti), and may have a single or multi-layer structure including the above material.

Referring to FIGS. 11 to 13, the fourth conductive layer 1700 may include the first sub-voltage line VL11, the second voltage line VL2, a first conductive pattern 1701, the first node connection line 1703, a second conductive pattern 1705, a third conductive pattern 1707, the sixth capacitor electrode CEs23, and the sixth hold capacitor electrode CEh14.

The first sub-voltage line VL11 may substantially extend in the first direction (e.g., the x-axis direction). The first sub-voltage line VL11 may be electrically connected to the first semiconductor pattern 1501 through a 12^{th} contact portion CNT 12, and may be electrically connected to the second sub-voltage line VL12 through a 22^{nd} contact portion CNT22. The first sub-voltage line VL11 may transmit the reference voltage VREF (see FIG. 2) to the second terminal of the third transistor T3.

The second voltage line VL2 may extend (or substantially extend) in the first direction (e.g., the x-axis direction). The second voltage line VL2 may be electrically connected to the third semiconductor pattern 1505 (see FIG. 8) through a 19^{th} contact portion CNT19. The second voltage line VL2 may transmit the initialization voltage Vint (see FIG. 2) to the second terminal of the fourth transistor T4 (see FIG. 2).

The first conductive pattern 1701 may be electrically connected to the first semiconductor pattern 1501 through a 9^{th} contact portion CNT9, and may be electrically connected to the data line DL through a 21^{st} contact portion CNT21. That is, the first conductive pattern 1701 may connect the first terminal of the second transistor T2 to the data line DL.

The first node connection line 1703 may be electrically connected to the first semiconductor pattern 1501 through a 10^{th} contact portion CNT10, and may be electrically connected to the first capacitor electrode CEs13 (see FIG. 9) through the 11^{th} contact portion CNT11. The 10^{th} contact portion CNT10 may be located between the second terminal of the second transistor T2 and the first terminal of the third transistor T3. As described above, because the first capacitor electrode CEs13 is integrally provided with the first gate electrode Ga of the first transistor T1, the first node connection line 1703 may correspond to a part of the first node N1 (see FIG. 2).

The first node connection line 1703 may extend in the second direction (e.g., the y-axis direction). In a plan view, the first scan line GWL may intersect the first node connection line 1703. Accordingly, in a plan view (e.g., a view perpendicular or normal with respect to a display surface of the display panel 10), a parasitic capacitance of the first node N1 may be formed in an area where the first scan line GWL and the first node connection line 1703 intersect each other. Such an increase in the parasitic capacitance may cause a threshold voltage deviation of the first transistor T1 in a source follower type pixel circuit in which the storage capacitor Cst (see FIG. 2) is located between the first node N1 and the second node N2 (see FIG. 2). The threshold voltage deviation of the first transistor T1 may cause a luminance distribution for each pixel. Accordingly, in order to reduce the parasitic capacitance of the first node N1, in a plan view, a portion of the first source region of the first transistor T1 may overlap an area where the first scan line GWL and the first node connection line 1703 overlap each other. In other words, in a plan view, in an area where the first scan line GWL and the first node connection line 1703 overlap each other, the first portion 1503P1 of the second semiconductor pattern 1503 may be located between the first scan line GWL and the first node connection line 1703, to shield the first scan line GWL.

In this case, because the first portion 1503P1 of the second semiconductor pattern 1503 is a first source region electrically connected to the second node N2, a capacitance formed between the first portion 1503P1 and the first node connection line 1703 may increase a total capacitance of the storage capacitor Cst.

The second conductive pattern 1705 may be electrically connected to the second semiconductor pattern 1503 through a 17^{th} contact portion CNT17, and may be electrically connected to the second driving voltage line PL2 through a 23^{rd} contact portion CNT23. The second conductive pattern 1705 may connect the second driving voltage line PL2 (see FIG. 12) to the first terminal of the fifth transistor T5 (see FIG. 2).

The third conductive pattern 1707 may be electrically connected to the third semiconductor pattern 1505 (see FIG. 8) through an 18^{th} contact portion CNT18, and may be electrically connected to a connection electrode CM through a 24^{th} contact portion CNT24. The third conductive pattern 1707 may connect the first terminal of the fourth transistor T4 and the second terminal of the sixth transistor T6 (see FIG. 2) to a pixel electrode of the organic light-emitting diode OLED (see FIG. 2) through the connection electrode CM.

The sixth capacitor electrode CEs23 may be any one of capacitor electrodes corresponding to the second electrode CEs2 (see FIG. 2) of the storage capacitor Cst. The sixth capacitor electrode CEs23 may be electrically connected to the second semiconductor pattern 1503 through the 13^{th} contact portion CNT13, may be electrically connected to the second capacitor electrode CEs22 (see FIG. 7) through the 14^{th} contact portion CNT14, may be electrically connected to the fifth hold capacitor electrode CEh23 (see FIG. 9) through a 15^{th} contact portion CNT15, and may be electrically connected to the third semiconductor pattern 1505 through a 16^{th} contact portion CNT16. Accordingly, the first portion 1503P1 corresponding to the first source region of the first transistor T1 may be electrically connected to the second capacitor electrode CEs22 through the sixth capacitor electrode CEs23.

As described above, because capacitor electrodes constituting the first electrode CEs1 (see FIG. 2) of the storage capacitor Cst and capacitor electrodes constituting the second electrode CEs2 (see FIG. 2) are alternately stacked, a total capacitance of the storage capacitor Cst may be increased.

The sixth hold capacitor electrode CEh14 may be any one of hold capacitor electrodes corresponding to the first electrode CEh1 (see FIG. 2) of the hold capacitor Chd (see FIG. 2). The sixth hold capacitor electrode CEh14 may be electrically connected to the fourth hold capacitor electrode CEh13 (see FIG. 7) through a 20^{th} contact portion CNT20.

As described above, because hold capacitor electrodes constituting the first electrode CEh1 (see FIG. 2) of the hold capacitor Chd and hold capacitor electrodes constituting the second electrode CEh2 (see FIG. 2) are alternately stacked, a total capacitance of the hold capacitor Chd may be increased. When a total capacitance of the hold capacitor Chd increases, a current control voltage width (data swing range) may decrease during the pixel circuit is driven, and thus, the display apparatus may display a higher-quality image.

A fifth conductive layer 1800 of FIG. 12 may be located on the fourth conductive layer 1700 (see FIG. 11). The fifth conductive layer 1800 may include a conductive material including molybdenum (Mo), aluminum (Al), copper (Cu), or titanium (Ti), and may have a single or multi-layer structure including the above material.

Referring to FIGS. 11 to 12, the fifth conductive layer 1800 may include the data line DL, the second driving voltage line PL2, the second sub-voltage line VL12, and the connection electrode CM.

The data line DL may substantially extend in the second direction (e.g., the y-axis direction), and may be connected to the first conductive pattern 1701 through the 21^{st} contact portion CNT21. That is, the data line DL may be electrically connected to the first terminal of the second transistor T2 (see FIG. 2) through the first conductive pattern 1701.

The second driving voltage line PL2 may substantially extend in the second direction (e.g., the y-axis direction), and may be connected to the second conductive pattern 1705 through the 23^{rd} contact portion CNT23. The second driving voltage line PL2 may be electrically connected to the first terminal of the fifth transistor T5 (see FIG. 2) through the 23^{rd} contact portion CNT23. According to some embodiments, the second driving voltage line PL2 may define a fourth hole H4 overlapping the first node connection line 1703 in a plan view. Because the fourth hole H4 overlaps the first node connection line 1703, a parasitic capacitance between the second driving voltage line PL2 and the first node connection line 1703 may be prevented or reduced.

The second sub-voltage line VL12 may substantially extend in the second direction (e.g., the y-axis direction), and may be connected to the first sub-voltage line VL11 through a 22^{nd} contact portion CNT22. The first sub-voltage line VL11 and the second sub-voltage line VL12 may intersect each other, and may form a mesh shape in an entire surface of the display area DA (see FIG. 1).

The connection electrode CM may be connected to the third conductive pattern 1707 through the 24^{th} contact portion CNT24, and may be connected to the pixel electrode of the organic light-emitting diode OLED (see FIG. 2) through a 25^{th} contact portion CNT25. That is, the connection electrode CM may electrically connect the pixel electrode of the organic light-emitting diode OLED to the first terminal of the fourth transistor T4 (see FIG. 2) and the second terminal of the sixth transistor T6 (see FIG. 2) through the third conductive pattern 1707.

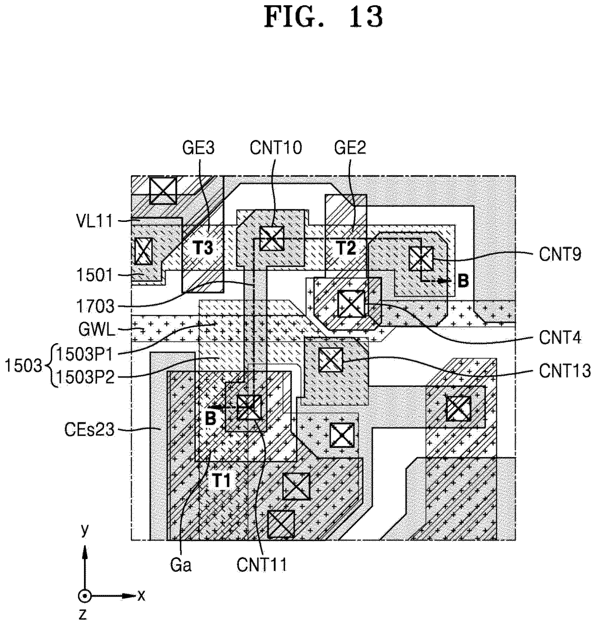

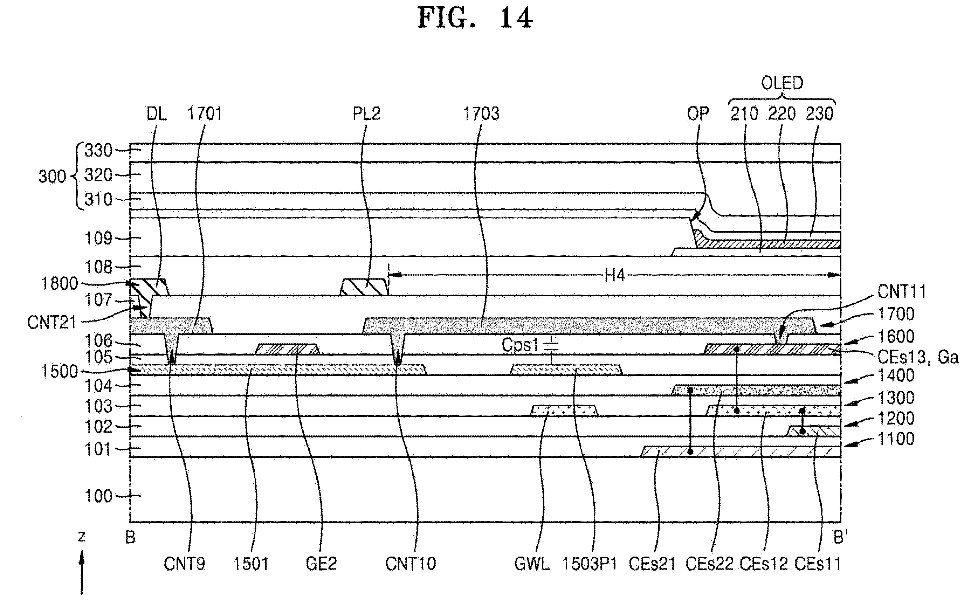

FIG. 13 is an enlarged view schematically illustrating an arrangement of a portion of a display apparatus, according to some embodiments. FIG. 14 is a cross-sectional view schematically illustrating the display apparatus of FIG. 13, taken along line B-B'. FIG. 13 illustrates only portions of the first conductive layer 1300 (see FIG. 6), the semiconductor layer 1500 (see FIG. 8), the third conductive layer 1600 (see FIG. 9), and the fourth conductive layer 1700 (see FIG. 11), to describe an arrangement of the first node connection line 1703, the first scan line GWL, and the first portion 1503P1 of the second semiconductor pattern 1503.

Referring to FIG. 13, the first scan line GWL may extend on the substrate 100 (see FIG. 14) in the first direction (e.g., the x-axis direction).

The second semiconductor pattern 1503 may include the first portion 1503P1 having at least part overlapping the first scan line GWL and the second portion 1503P2 bent and extending from the first portion 1503P1. The first portion 1503P1 of the second semiconductor pattern 1503 may be electrically connected to the sixth capacitor electrode CEs23 through the 13^{th} contact portion CNT13. That is, the first portion 1503P1 of the second semiconductor pattern 1503 may correspond to a part of the first source region of the first transistor T1. The second portion 1503P2 of the second semiconductor pattern 1503 may include the driving active region and the first drain region of the first transistor T1.

The first node connection line 1703 may be electrically connected to the first semiconductor pattern 1501 through the 10^{th} contact portion CNT10, and may be electrically connected to the first capacitor electrode CEs13 (see FIG. 9) through the 11^{th} contact portion CNT11. The 10^{th} contact portion CNT10 may be located between the second terminal of the second transistor T2 and the first terminal of the third transistor T3. Because the first capacitor electrode CEs13 is integrally provided with the first gate electrode Ga of the first transistor T1, the first node connection line 1703 may correspond to a part of the first node N1 (see FIG. 2).

The first node connection line 1703 may extend in the second direction (e.g., the y-axis direction). In a plan view, the first scan line GWL may intersect the first node connection line 1703.

In a plan view, a portion of the first source region of the first transistor T1 may overlap an area where the first scan line GWL and the first node connection line 1703 overlap each other. In other words, in a plan view, in an area where the first scan line GWL and the first node connection line 1703 overlap each other, the first portion 1503P1 of the second semiconductor pattern 1503 may be located between the first scan line GWL and the first node connection line 1703, to shield the first scan line GWL.

In this case, because the first portion 1503P1 of the second semiconductor pattern 1503 is a first source region electrically connected to the second node N2 (see FIG. 2), a capacitance formed between the first portion 1503P1 and the first node connection line 1703 may increase a total capacitance of the storage capacitor Cst (see FIG. 2).

Referring to FIG. 14, the first lower metal layer 1100, the second lower metal layer 1200, the first conductive layer 1300, the second conductive layer 1400, the semiconductor layer 1500, the third conductive layer 1600, the fourth conductive layer 1700, and the fifth conductive layer 1800 may be sequentially stacked on the substrate 100.

The first lower metal layer 1100 may be located on the substrate 100. The first lower metal layer 1100 may include the third capacitor electrode CEs21.

A first barrier layer 101 may be located on the substrate 100 to cover the first lower metal layer 1100. The first barrier layer 101 may prevent, reduce, or minimize penetration of impurities from the substrate 100. The first barrier layer 101 may include an inorganic material such as oxide or nitride, an organic material, or a combination of an organic material and an inorganic material, and may have a single or multi-layer structure including an inorganic material and an organic material.

The second lower metal layer 1200 may be located on the first barrier layer 101. The second lower metal layer1200 may include the fifth capacitor electrode CEs11.

A second barrier layer 102 may be located on the first barrier layer 101 to cover the second lower metal layer 1200. The second barrier layer 102 may include an inorganic material such as oxide or nitride, an organic material, or a combination of an organic material and an inorganic material, and may have a single or multi-layer structure including an inorganic material and an organic material.

The first conductive layer 1300 may be located on the second barrier layer 102. The first conductive layer 1300 may include the first scan line GWL and the fourth capacitor electrode CEs12. The fourth capacitor electrode CEs12 may be electrically connected to the fifth capacitor electrode CEs11 included in the second lower metal layer 1200.

A first insulating layer 103 may be located on the second barrier layer 102 to cover the first conductive layer 1300. The first insulating layer 103 may include an inorganic material such as oxide or nitride, an organic material, or a combination of an organic material and an inorganic material, and may have a single or multi-layer structure including an inorganic material and an organic material.

The second conductive layer 1400 may be located on the first insulating layer 103. The second conductive layer 1400 may include the second capacitor electrode CEs22. The second capacitor electrode CEs22 may be electrically connected to the third capacitor electrode CEs21 included in the first lower metal layer 1100. Also, the second capacitor electrode CEs22 may be integrally provided with the second gate electrode Gb (see FIG. 2) of the first transistor T1 overlapping the driving active region of the first transistor T1 (see FIG. 2).

A second insulating layer 104 may be located on the first insulating layer 103 to cover the second conductive layer 1400. The second insulating layer 104 may include an inorganic material such as oxide or nitride, an organic material, or a combination of an organic material and an inorganic material, and may have a single or multi-layer structure including an inorganic material and an organic material.

The semiconductor layer 1500 may be located on the second insulating layer 104. The semiconductor layer 1500 may include the first semiconductor pattern 1501 and the second semiconductor pattern 1503 (see FIG. 8). The first semiconductor pattern 1501 may include an active region of the second transistor T2 overlapping the gate electrode GE2 of the second transistor T2 (see FIG. 2) in a plan view.

The first portion 1503P1 of the second semiconductor pattern 1503 may overlap the first scan line GWL in a plan view. The first portion 1503P1 may be located between the first scan line GWL and the first node connection line 1703. A third insulating layer 105 may be located on the second insulating layer 104 to cover the first portion 1503P1 and the semiconductor layer 1500.

The third insulating layer 105 may include an inorganic material such as oxide or nitride, an organic material, or a combination of an organic material and an inorganic material, and may have a single or multi-layer structure including an inorganic material and an organic material.

The third conductive layer 1600 may be located on the third insulating layer 105. The third conductive layer 1600 may include the gate electrode GE2 of the second transistor T2 and the first capacitor electrode CEs13. The gate electrode GE2 of the second transistor T2 may overlap a portion of the first semiconductor pattern 1501. The first capacitor electrode CEs13 may be electrically connected to the fourth capacitor electrode CEs12 included in the first conductive layer 1300. Also, the first capacitor electrode CEs13 may be integrally provided with the first gate electrode Ga (see FIG. 2) of the first transistor T1 overlapping the driving active region of the first transistor T1 (see FIG. 2).

A fourth insulating layer 106 may be located on the third insulating layer 105 to cover the third conductive layer 1600. The fourth insulating layer 106 may include an inorganic material such as oxide or nitride, an organic material, or a combination of an organic material and an inorganic material, and may have a single or multi-layer structure including an inorganic material and an organic material.

The fourth conductive layer 1700 may be located on the fourth insulating layer 106. The fourth conductive layer 1700 may include the first conductive pattern 1701 and the first node connection line 1703.

The first conductive pattern 1701 may be electrically connected to the first semiconductor pattern 1501 through the 9^{th} contact portion CNT9, and may be electrically connected to the data line DL through the 21^{st} contact portion CNT21.

The first node connection line 1703 may be electrically connected to the first semiconductor pattern 1501 through the 10^{th} contact portion CNT10, and may be electrically connected to the first capacitor electrode CEs13 through the 11^{th} contact portion CNT11. The first node connection line 1703 may overlap the first scan line GWL in a plan view. In a plan view, because the first portion 1503P1 of the second semiconductor pattern 1503 (see FIG. 8) is located in an area where the first node connection line 1703 and the first scan line GWL intersect each other, a parasitic capacitance between the first node connection line 1703 and the first scan line GWL may be prevented or reduced.

Also, because the first node connection line 1703 is electrically connected to the first capacitor electrode CEs13, a first capacitance Cps1 between the first node connection line 1703 and the first portion 1503P1 that is a portion of the first source region of the first transistor T1 may be included in a total capacitance of the storage capacitor Cst (see FIG. 2).

A first planarization layer 107 may be located on the fourth insulating layer 106 to cover the fourth conductive layer 1700. The first planarization layer 107 may have a single or multi-layer structure including an organic material, to provide a flat top surface. The first planarization layer 107 may include benzocyclobutene (BCB), polyimide, hexamethyldisiloxane (HMDSO), a general-purpose polymer such as polystyrene (PS), polymethyl methacrylate (PMMA), a polymer derivative having a phenol-based group, an acrylic-based polymer, an imide-based polymer, an aryl ether-based polymer, an amide-based polymer, a fluorinated-based polymer, a p-xylene-based polymer, a vinyl alcohol-based polymer, or a blend thereof.

The fifth conductive layer 1800 may be located on the first planarization layer 107. The fifth conductive layer 1800 may include the data line DL and the second driving voltage line PL2.

The data line DL may be connected to the first conductive pattern 1701 through the 21^{st} contact portion CNT21. That is, the data line DL may be electrically connected to the first terminal of the second transistor T2 (see FIG. 2) through the first conductive pattern 1701.

The second driving voltage line PL2 may define the fourth hole H4 overlapping the first node connection line 1703 in a plan view. Because the fourth hole H4 overlaps the first node connection line 1703, a parasitic capacitance between the second driving voltage line PL2 and the first node connection line 1703 may be prevented or reduced.

A second planarization layer 108 may be located on the first planarization layer 107 to cover the fifth conductive layer 1800. The second planarization layer 108 may have a single or multi-layer structure formed of an organic material, and has a flat top surface. The second planarization layer 108 may include benzocyclobutene (BCB), polyimide, hexamethyldisiloxane (HMDSO), a general-purpose polymer such as polystyrene (PS), polymethyl methacrylate (PMMA), a polymer derivative having a phenol-based group, an acrylic-based polymer, an imide-based polymer, an aryl ether-based polymer, an amide-based polymer, a fluorinated-based polymer, a p-xylene-based polymer, a vinyl alcohol-based polymer, or a blend thereof.

An organic light-emitting diode OLED may be located on the second planarization layer 108. The organic light-emitting diode OLED may include a pixel electrode 210, a counter electrode 230, and an intermediate layer 220 located between the pixel electrode 210 and the counter electrode 230.

The pixel electrode 210 may be located on the second planarization layer 108. The pixel electrode 210 may be a (semi-)transmissive electrode or a reflective electrode. In some embodiments, the pixel electrode 210 may include a reflective layer formed of Ag, Mg, Al, Pt, Pd, Au, Ni, Nd, Ir, Cr, or a compound thereof, and a transparent or semi-transparent electrode layer formed on the reflective layer. The transparent or semi-transparent electrode layer may include at least one selected from the group consisting of indium tin oxide (ITO), indium zinc oxide (IZO), zinc oxide (ZnO), indium oxide (In₂O₃), indium gallium oxide (IGO), and aluminum zinc oxide (AZO). In some embodiments, the pixel electrode 210 may include ITO/Ag/ITO.

A pixel-defining film 109 may be located on the second planarization layer 108 to cover an edge of the pixel electrode 210. The pixel-defining film 109 may define an opening OP through which a central portion of the pixel electrode 2101 is exposed. An emission area of the organic light-emitting diode OLED may be defined by the opening OP.

Because the pixel-defining film 109 increases a distance between the edge of the pixel electrode 210 and the counter electrode 230, instances of an arc or the like occurring at the edge of the pixel electrode 210 may be prevented or reduced. The pixel-defining film 109 may be formed of at least one organic insulating material selected from the group consisting of polyimide resin, polyamide resin, an acrylic resin, benzocyclobutene resin, and a phenolic resin by using spin coating or the like. According to some embodiments, the pixel-defining film 109 may include a light-shielding material, and may be black. The light-shielding material may include carbon black, carbon nanotubes, a resin or paste including a black dye, metal particles (e.g., nickel, aluminum, molybdenum, or an alloy thereof), metal oxide particles (e.g., chromium oxide), or metal nitride particles (e.g., chromium nitride). When the pixel-defining film 109 includes a light-shielding material, the reflection of external light due to conductive layers located under the pixel-defining film 109 may be reduced.

The intermediate layer 220 may include an emission layer located in the opening OP defined by the pixel-defining film 109. The emission layer may include an organic material including a fluorescent or phosphorescent material emitting red, green, blue, or white light. The emission layer may be formed of a low molecular weight organic material or a high molecular weight organic material. The intermediate layer 220 may include functional layers such as a hole transport layer (HTL), a hole injection layer (HIL), an electron transport layer (ETL), or an electron injection layer (EIL). The functional layers may be selectively further located under or over the emission layer. The functional layers may be integrally formed over a plurality of organic light-emitting diodes OLED.

The counter electrode 230 may be a light-transmitting electrode or a reflective electrode. According to some embodiments, the counter electrode 230 may be a transparent or semi-transparent electrode, and may include a metal thin film having a low work function including lithium (Li), calcium (Ca), LiF, aluminum (Al), silver (Ag), magnesium (Mg), or a compound thereof, or including multi-layer materials such as LiF/Ca or LiF/Al. Also, a transparent conductive oxide (TCO) film such as ITO, IZO, ZnO, or In₂O₃ may be further located on the metal thin film. The counter electrode 230 may be located over the display area DA (see FIG. 1), and may be located on the emission layer 220 and the pixel-defining film 109. The counter electrode 230 may be integrally formed over a plurality of organic light-emitting diodes OLED.

An encapsulation layer 300 may be located on the organic light-emitting diode OLED. The encapsulation layer 300 may cover the display area DA (see FIG. 1) and may extend to at least a part of the peripheral area PA (see FIG. 1). The encapsulation layer 300 may include at least one inorganic encapsulation layer and at least one organic encapsulation layer. For example, the encapsulation layer 300 may include a first inorganic encapsulation layer 310, a second inorganic encapsulation layer 330, and an organic encapsulation layer 320 located between the first inorganic encapsulation layer 310 and the second inorganic encapsulation layer 330.

Each of the first inorganic encapsulation layer 310 and the second inorganic encapsulation layer 330 may have a single or multi-layer structure including an inorganic material such as silicon oxide, silicon nitride, or silicon oxynitride.

The organic encapsulation layer 320 may include a monomer-based material or a polymer-based material. Examples of the polymer-based material may include an acrylic resin, an epoxy resin, polyimide resin, and polyethylene resin.

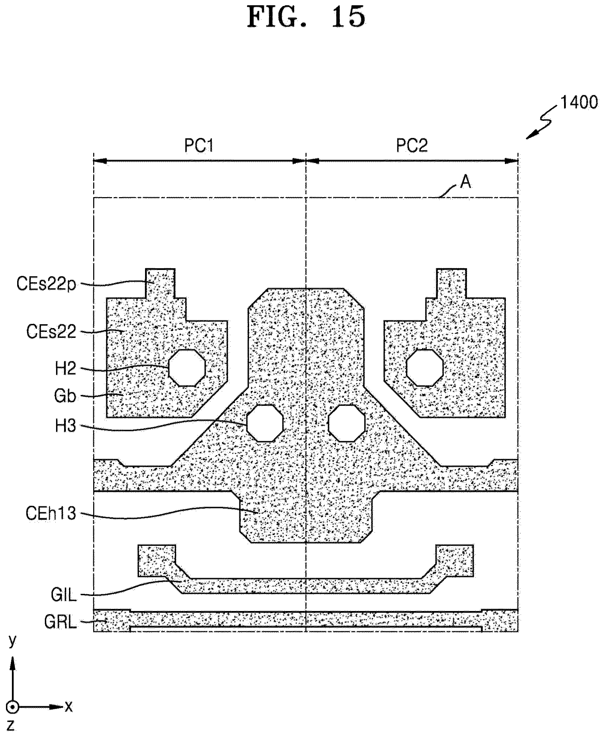

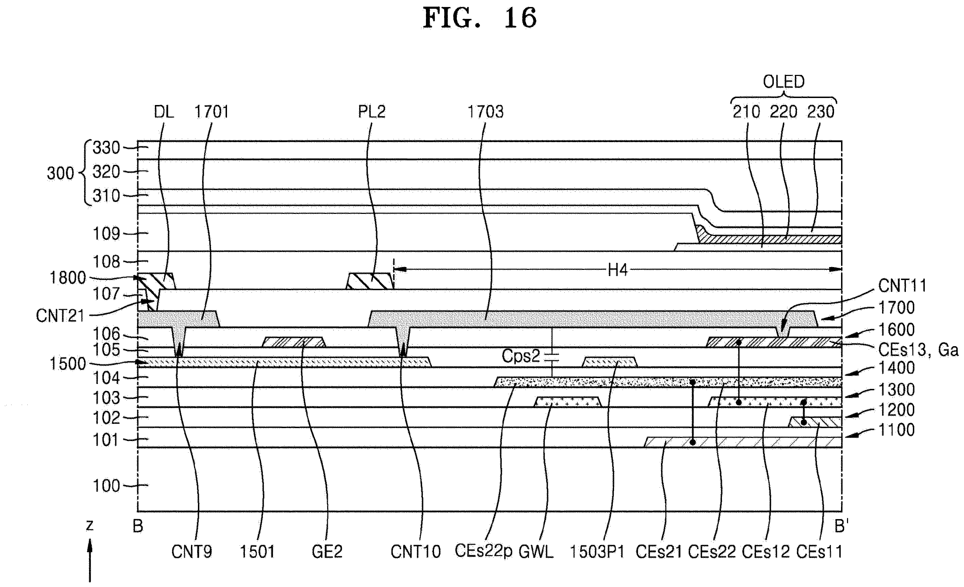

FIG. 15 is a view schematically illustrating an arrangement of a portion of a second conductive layer of a display apparatus, according to some embodiments. FIG. 16 is a cross-sectional view schematically illustrating a portion of the display apparatus of FIG. 15, FIG. 16 being taken along a cross-sectional line of FIG. 15 similar to a line B-B' of FIG. 13. FIG. 15 is similar to FIG. 7 except that the second capacitor electrode CEs22 includes a protrusion CEs22p. The description of the same or similar elements will be omitted, and a difference will be mainly described.

Referring to FIGS. 15 and 16, the second capacitor electrode CEs22 may include the protrusion CEs22p protruding in the second direction (e.g., the y-axis direction) to overlap a portion of the first scan line GWL. In a plan view, the protrusion CEs22p may overlap an area where the first scan line GWL and the first node connection line 1703 intersect each other.

The second capacitor electrode CEs22 and the second gate electrode Gb of the first transistor T1 (see FIG. 2) may be integrally provided. The second capacitor electrode CEs22 may be electrically connected to the second node N2 (see FIG. 2).

Because the protrusion CEs22p of the second capacitor electrode CEs22 is located in an area where the first node connection line 1703 and the first scan line GWL intersect each other, a parasitic capacitance between the first node connection line 1703 and the first scan line GWL may be prevented or reduced.

Also, because the first node connection line 1703 is electrically connected to the first capacitor electrode CEs13, a second capacitance Cps2 between the first node connection line 1703 and the protrusion CEs22p that is a portion of the second capacitor electrode CEs22 may be included in a total capacitance of the storage capacitor Cst (see FIG. 2).

As the second capacitor electrode CEs22 shields the first scan line GWL, the first portion 1503P1 of the second semiconductor pattern 1503 (see FIG. 8) may not overlap the first scan line GWL. However, the invention is not limited thereto, and the first portion 1503P1 of the second semiconductor pattern 1503 may overlap a portion of the first scan line GWL.

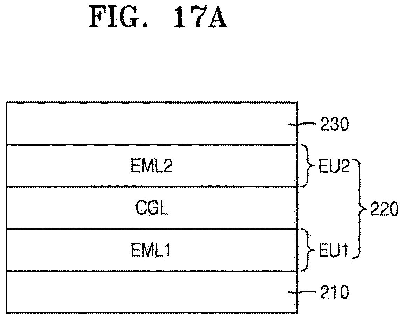

FIGS. 17A to 18B are cross-sectional views illustrating a structure of an organic light-emitting diode included in a display apparatus, according to some embodiments.

Referring to FIGS. 17A to 17D, the organic light-emitting diode OLED (see FIG. 2) according to some embodiments may include the pixel electrode 210, the counter electrode 230, and the intermediate layer 220 between the pixel electrode 210 (first electrode or anode) and the counter electrode 230 (second electrode or cathode).

The pixel electrode 210 may include a light-transmitting conductive oxide such as indium tin oxide (ITO), indium zinc oxide (IZO), zinc oxide (ZnO), indium oxide (In₂O₃), indium gallium oxide (IGO), or aluminum zinc oxide (AZO). The pixel electrode 210 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof. For example, the pixel electrode 210 may have a three-layer structure including ITO/Ag/ITO.

The counter electrode 230 may be located on the intermediate layer 220. The counter electrode 230 may include a metal having a low work function, an alloy, an electrically conductive compound, or any combination thereof. For example, the counter electrode 230 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), indium tin oxide (ITO), indium zinc oxide (IZO), or any combination thereof. The counter electrode 230 may be a transmissive electrode, a semi-transmissive electrode, or a reflective electrode.

The intermediate layer 220 may include a high molecular weight or low molecular weight organic material emitting light of a certain color. The intermediate layer 220 may further include a metal-containing compound such as an organo-metallic compound or an inorganic material such as quantum dots, in addition to various organic materials.

According to some embodiments, the intermediate layer 220 may include one emission layer, and a first functional layer and a second functional layer respectively located under and over the emission layer. For example, the first functional layer may include a hole transport layer (HTL), or may include a hole transport layer and a hole injection layer (HIL). The second functional layer may include an electron transport layer (ETL) and/or an electron injection layer (EIL). The first functional layer or the second functional layer may be omitted. The first functional layer and the second functional layer may be integrally formed to correspond to a plurality of organic light-emitting diodes OLED included in the display area DA (see FIG. 1).

According to some embodiments, the intermediate layer 220 may include two or more light-emitting units that are sequentially stacked between the pixel electrode 210 and the counter electrode 230, and a charge generation layer CGL located between the two or more light-emitting units. When the intermediate layer 220 includes the light-emitting unit and the charge generation layer CGL, the organic light-emitting diode OLED may be a tandem light-emitting device. Because the organic light-emitting diode OLED has a structure in which a plurality of light-emitting units are stacked, color purity and luminous efficiency may be improved.

One light-emitting unit may include an emission layer, and a first functional layer and a second functional layer respectively located under and over the emission layer. The charge generation layer CGL may include a negative charge generation layer and a positive charge generation layer. Due to the negative charge generation layer and the positive charge generation layer, the luminous efficiency of the organic light-emitting diode OLED that is a tandem light-emitting device including a plurality of emission layers may be further improved.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer include a host and a dopant. The host may include an organic material. The dopant may include a metal material.

According to some embodiments, as shown in FIG. 17A, the organic light-emitting diode OLED may include a first light-emitting unit EU1 including a first emission layer EML1 and a second light-emitting unit EU2 including a second emission layer EML2 which are sequentially stacked. The charge generation layer CGL may be provided between the first light-emitting unit EU1 and the second light-emitting unit EU2. For example, the organic light-emitting diode OLED may include the pixel electrode 210, the first emission layer EML1, the charge generation layer CGL, the second emission layer EML2, and the counter electrode 230 which are sequentially stacked. A first functional layer and a second functional layer may be respectively provided under and over the first emission layer EML1. A first functional layer and a second functional layer may be respectively provided under and over the second emission layer EML2. The first emission layer EML1 may be a blue emission layer and the second emission layer EML2 may be a yellow emission layer.

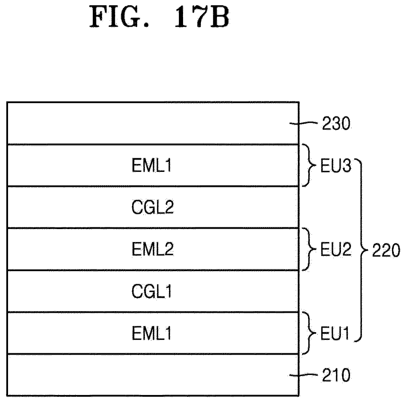

According to some embodiments, as shown in FIG. 17B, the organic light-emitting diode OLED (see FIG. 2) may include a first light-emitting unit EU1 and a third light-emitting unit EU3 including a first emission layer EML1, and a second light-emitting unit EU2 including a second emission layer EML2. The first charge generation layer CGL1 may be provided between the first light-emitting unit EU1 and the second light-emitting unit EU2, and the second charge generation layer CGL2 may be provided between the second light-emitting unit EU2 and the third light-emitting unit EU3. For example, the organic light-emitting diode OLED may include the pixel electrode 210, the first emission layer EML1, the first charge generation layer CGL1, the second emission layer EML2, the second charge generation layer CGL2, the first emission layer EML1, and the counter electrode 230 which are sequentially stacked. A first functional layer and a second functional layer may be respectively provided under and over the first emission layer EML1. A first functional layer and a second functional layer may be respectively provided under and over the second emission layer EML2. The first emission layer EML1 may be a blue emission layer and the second emission layer EML2 may be a yellow emission layer.

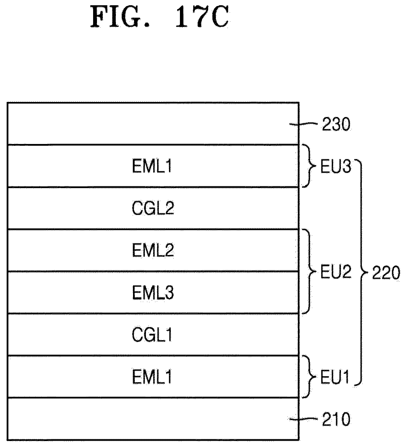

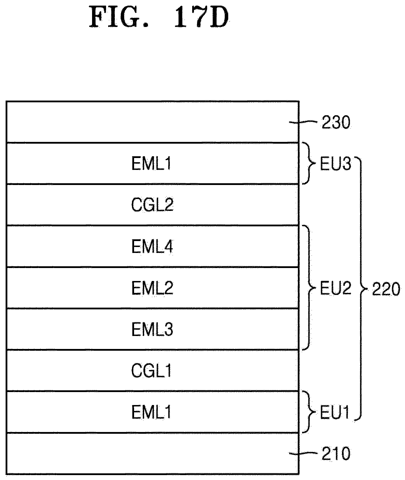

According to some embodiments, in the organic light-emitting diode OLED, the second light-emitting unit EU2 may further include a third emission layer EML3 (see FIG. 17C) and/or a fourth emission layer EML4 (see FIG. 17D) that is located under and/or over the second emission layer EML2 to directly contact the second emission layer EML2, in addition to the second emission layer EML2. Direct contact may mean that there is no layer between the second emission layer EML2 and the third emission layer EML3 and/or between the second emission layer EML2 and the fourth emission layer EML4. The third emission layer EML3 may be a red emission layer, and the fourth emission layer EML4 may be a green emission layer.

For example, as shown in FIG. 17C, the organic light-emitting diode OLED may include the pixel electrode 210, the first emission layer EML1, the first charge generation layer CGL1, the third emission layer EML3, the second emission layer EML2, the second charge generation layer CGL2, the first emission layer EML1, and the counter electrode 230 which are sequentially stacked. Alternatively, as shown in FIG. 17D, the organic light-emitting diode OLED may include the pixel electrode 210, the first emission layer EML1, the first charge generation layer CGL1, the third emission layer EML3, the second emission layer EML2, the fourth emission layer EML4, the second charge generation layer CGL2, the first emission layer EML1, and the counter electrode 230 which are sequentially stacked.

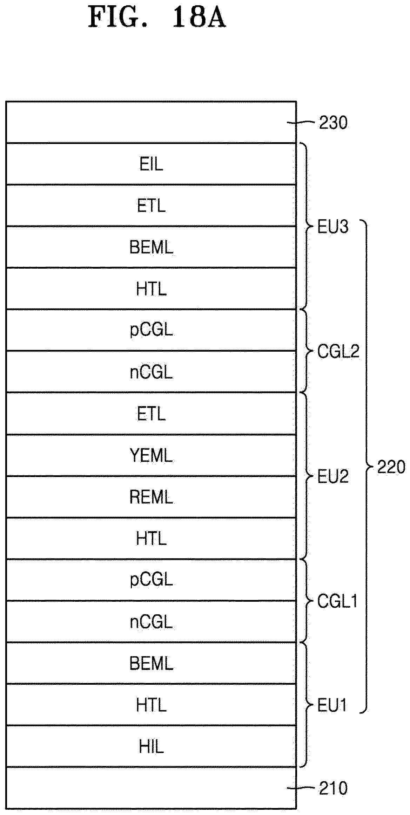

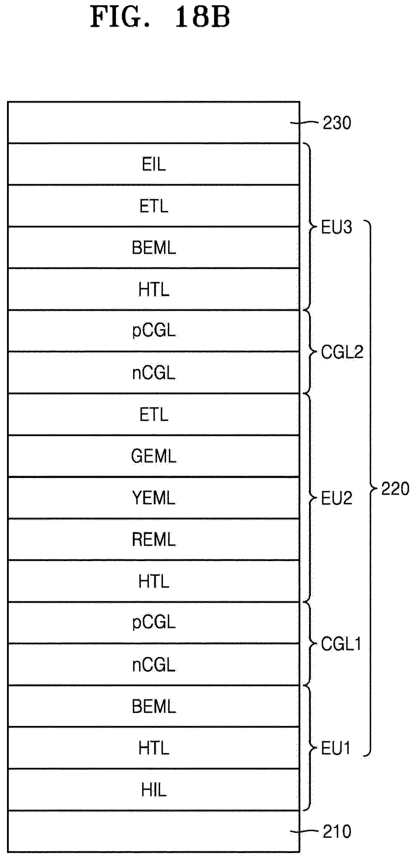

FIG. 18A is a cross-sectional view illustrating the organic light-emitting diode of FIG. 17C. FIG. 18B is a cross-sectional view illustrating the organic light-emitting diode of FIG. 17D.

Referring to FIG. 18A, the organic light-emitting diode OLED may include the first light-emitting unit EU1, the second light-emitting unit EU2, and the third light-emitting unit EU3 which are sequentially stacked. The first charge generation layer CGL1 may be provided between the first light-emitting unit EU1 and the second light-emitting unit EU2, and the second charge generation layer CGL2 may be provided between the second light-emitting unit EU2 and the third light-emitting unit EU3. Each of the first charge generation layer CGL1 and the second charge generation layer CGL2 may include a negative charge generation layer nCGL and a positive charge generation layer pCGL.

The first light-emitting unit EU1 may include a blue emission layer BEML. The first light-emitting unit EU1 may further include a hole injection layer HIL and a hole transport layer HTL between the pixel electrode 210 and the blue emission layer BEML. According to some embodiments, a p-doped layer may be further provided between the hole injection layer HIL and the hole transport layer HTL. The p-doped layer may be formed by doping the hole injection layer HIL with a p-type doping material. According to some embodiments, at least one of a blue light auxiliary layer, an electron blocking layer, or a buffer layer may be further provided between the blue emission layer BEML and the hole transport layer HTL. The blue light auxiliary layer may improve light emission efficiency of the blue emission layer BEML. The blue light auxiliary layer may improve light emission efficiency of the blue emission layer BEML by adjusting hole charge balance. The electronic blocking layer may prevent or reduce instances of electron injection into the hole transport layer HTL. The buffer layer may compensate for a resonance distance according to a wavelength of light emitted from the emission layer.

The second light-emitting unit EU2 may include a yellow emission layer YEML and a red emission layer REML located under the yellow emission layer YEML to directly contact the yellow emission layer YEML. The second light-emitting unit EU2 may further include a hole transport layer HTL between the red emission layer REML and the positive charge generation layer pCGL of the first charge generation layer CGL1, and may further include an electron transport layer ETL between the yellow emission layer YEML and the negative charge generation layer nCGL of the second charge generation layer CGL2.

The third light-emitting unit EU3 may include a blue emission layer BEML. The third light-emitting unit EU3 may further include a hole transport layer HTL between the blue emission layer BEML and the positive charge generation layer pCGL of the second charge generation layer CGL2. The third light-emitting unit EU3 may further include an electron transport layer ETL and an electron injection layer EIL between the blue emission layer BEML and the counter electrode 230. The electron transport layer ETL may have a single or multi-layer structure. According to some embodiments, at least one of a blue light auxiliary layer, an electron blocking layer, or a buffer layer may be further provided between the blue emission layer BEML and the hole transport layer HTL. At least one of a hole blocking layer or a buffer layer may be further provided between the blue emission layer BEML and the electron transport layer ETL. The hole blocking layer may prevent or reduce instances of a hole injection into the electron transport layer ETL.

The organic light-emitting diode OLED of FIG. 18B is the same as the organic light-emitting diode OLED of FIG. 18A except for a stacked structure of the second light-emitting unit EU2. Referring to FIG. 18B, the second light-emitting unit EU2 may include a yellow emission layer YEML, a red emission layer REML located under the yellow emission layer YEML to directly contact the yellow emission layer YEML, and a green emission layer GEML located over the yellow emission layer YEML to directly contact the yellow emission layer YEML. The second light-emitting unit EU2 may further include a hole transport layer HTL between the red emission layer REML and the positive charge generation layer pCGL of the first charge generation layer CGL1, and may further include an electron transport layer ETL between the green emission layer GEML and the negative charge generation layer nCGL of the second charge generation layer CGL2.

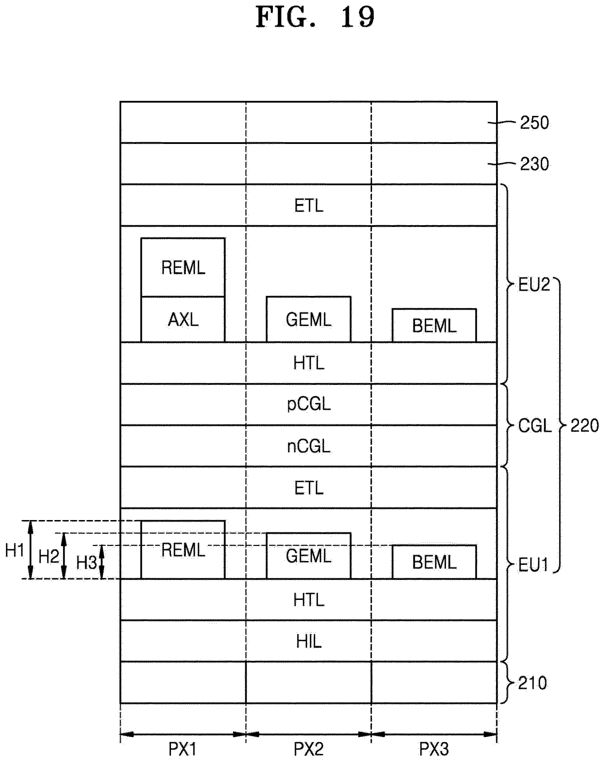

FIG. 19 is a cross-sectional view illustrating structures of organic light-emitting diodes included in a display apparatus, according to some embodiments.

Referring to FIG. 19, a display apparatus may include a plurality of pixels. The plurality of pixels may include a first pixel PX1, a second pixel PX2, and a third pixel PX3. Each of the first pixel PX1, the second pixel PX2, and the third pixel PX3 may include the pixel electrode 210, the counter electrode 230, and the intermediate layer 220. According to some embodiments, the first pixel PX1 may be a red pixel, the second pixel PX2 may be a green pixel, and the third pixel PX3 may be a blue pixel. A pixel may include an organic light-emitting diode OLED as a display element, and the organic light-emitting diode OLED of each pixel may be electrically connected to a pixel circuit.

The pixel electrode 210 may be independently provided in each of the first pixel PX1, the second pixel PX2, and the third pixel PX3.

The intermediate layer 220 of the organic light-emitting diode OLED of each of the first pixel PX1, the second pixel PX2, and the third pixel PX3 may include a first light-emitting unit EU1, a second light-emitting unit EU2, and a charge generation layer CGL between the first light-emitting unit EU1 and the second light-emitting unit EU2, which are sequentially stacked. The charge generation layer CGL may include a negative charge generation layer nCGL and a positive charge generation layer pCGL. The charge generation layer CGL may be a common layer continuously formed in the first pixel PX1, the second pixel PX2, and the third pixel PX3.

The first light-emitting unit EU1 of the first pixel PX1 may include a hole injection layer HIL, a hole transport layer HTL, a red emission layer REML, and an electron transport layer ETL which are sequentially stacked on the pixel electrode 210. The first light-emitting unit EU1 of the second pixel PX2 may include a hole injection layer HIL, a hole transport layer HTL, a green emission layer GEML, and an electron transport layer ETL which are sequentially stacked on the pixel electrode 210. The first light-emitting unit EU1 of the third pixel PX3 may include a hole injection layer HIL, a hole transport layer HTL, a blue emission layer BEML, and an electron transport layer ETL which are sequentially stacked on the pixel electrode 210. Each of the hole injection layer HIL, the hole transport layer HTL, and the electron transport layer ETL of the first light-emitting units EU1 may be a common layer continuously formed in the first pixel PX1, the second pixel PX2, and the third pixel PX3.

The second light-emitting unit EU2 of the first pixel PX1 may include a hole transport layer HTL, an auxiliary layer AXL, a red emission layer REML, and an electron transport layer ETL which are sequentially stacked on the charge generation layer CGL. The second light-emitting unit EU2 of the second pixel PX2 may include a hole transport layer HTL, a green emission layer GEML, and an electron transport layer ETL which are sequentially stacked on the charge generation layer CGL. The second light-emitting unit EU2 of the third pixel PX3 may include a hole transport layer HTL, a blue emission layer BEML, and an electron transport layer ETL which are sequentially stacked on the charge generation layer CGL. Each of the hole transport layer HTL and the electron transport layer ETL of the second light-emitting units EU2 may be a common layer continuously formed in the first pixel PX1, the second pixel PX2, and the third pixel PX3. According to some embodiments, in the second light-emitting unit EU2 of the first pixel PX1, the second pixel PX2, and the third pixel PX3, at least one of a hole blocking layer or a buffer layer may be further provided between the emission layer and the electron transport layer ETL.

A thickness H1 of the red emission layer REML, a thickness H2 of the green emission layer GEML, and a thickness H3 of the blue emission layer BEML may be determined according to a resonance distance. The auxiliary layer AXL is a layer added to adjust a resonance distance, and may include a resonance auxiliary material. For example, the auxiliary layer AXL may include the same material as that of the hole transport layer HTL.

Although the auxiliary layer AXL is provided only in the first pixel PX1 in FIG. 19, embodiments according to the present invention are not limited thereto. For example, the auxiliary layer AXL may be provided in at least one of the first pixel PX1, the second pixel PX2, or the third pixel PX3 to adjust a resonance distance of each of the first pixel PX1, the second pixel PX2, and the third pixel PX3.

The display apparatus may further include a capping layer 250 located outside the counter electrode 230. The capping layer 250 may improve light emission efficiency due to the principle of constructive interference. Accordingly, the light extraction efficiency of the organic light-emitting diode OLED may be improved, and thus, the light emission efficiency of the organic light-emitting diode OLED may be improved.

While the invention has been particularly shown and described with reference to embodiments thereof, they are provided for the purposes of illustration.

According to some embodiments as described above, a display apparatus for displaying a high-quality image may be implemented. However, the scope of embodiments according to the present invention is not limited by this effect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the scope as defined by the following claims.

## Claims

1. A display apparatus comprising:
a substrate (100);
a first scan line (GWL) on the substrate (100) and extending in a first direction;
a semiconductor layer (1500) on the substrate (100), and comprising a first drain region, a first source region extending in the first direction so that at least a portion (1503P1) of the first source region overlaps the first scan line (GWL), and a driving active region between the first drain region and the first source region;
a first gate electrode (Ga) on the semiconductor layer (1500) and overlapping the driving active region;
a second gate electrode (Gb) under the semiconductor layer (1500) and overlapping the driving active region; and
a first node connection line (1703) on the first gate electrode (Ga), electrically connected to the first gate electrode (Ga), and extending in a second direction that intersects the first direction.

2. The display apparatus of claim 1, wherein, in a plan view, the portion (1503P1) of the first source region overlaps an area where the first scan line (GWL) and the first node connection line (1703) intersect each other.

3. The display apparatus of at least one of claims 1 or 2, further comprising a storage capacitor (Cst) comprising a first capacitor electrode (CEs13) integrally provided with the first gate electrode (Ga) and a second capacitor electrode (CEs22) integrally provided with the second gate electrode (Gb).

4. The display apparatus of claim 3, wherein the second capacitor electrode (CEs22) is electrically connected to the first source region.

5. The display apparatus of claim 3 or 4, wherein the storage capacitor (Cst) further comprises a third capacitor electrode (CEs21) on the substrate (100) and a fourth capacitor electrode (CEs12) between the third capacitor electrode (CEs21) and the second capacitor electrode (CEs22),
wherein the first capacitor electrode (CEs13) is electrically connected to the fourth capacitor electrode (CEs12), and
the second capacitor electrode (CEs22) is electrically connected to the third capacitor electrode (CEs21).

6. The display apparatus of claim 5, wherein the storage capacitor (Cst) further comprises a fifth capacitor electrode (CEs11) between the third capacitor electrode (CEs21) and the fourth capacitor electrode (CEs12) and electrically connected to the fourth capacitor electrode (CEs12).

7. The display apparatus of claim 5 or 6, further comprising a hold capacitor (Chd) comprising a first hold capacitor electrode (CEh21) integrally provided with the third capacitor electrode (CEs21) and a second hold capacitor electrode (CEh11) on the first hold capacitor electrode (CEh21) and electrically connected to a first driving voltage line (PL1).

8. The display apparatus of claim 7, wherein the hold capacitor (Chd) further comprises a third hold capacitor electrode (CEh22) on the second hold capacitor electrode (CEh11) and electrically connected to the first hold capacitor electrode (CEh21) and a fourth hold capacitor electrode (CEh13) on the third hold capacitor electrode (CEh22) and electrically connected to the second hold capacitor electrode (CEh11).

9. The display apparatus of claim 8, wherein the hold capacitor (Chd) further comprises a fifth hold capacitor electrode (CEh23) on the fourth hold capacitor electrode (CEh13) and electrically connected to the first source region.

10. The display apparatus of at least one of claims 1 to 9, wherein the second gate electrode (Gb) comprises a protrusion (CEs22p) overlapping an area where the first scan line (GWL) and the first node connection line (1703) intersect each other in a plan view.

11. The display apparatus of at least one of claims 1 to 10, wherein the semiconductor layer (1500) comprises an oxide semiconductor material.

12. The display apparatus of at least one of claims 1 to 11, further comprising a second driving voltage line (PL2) extending in the second direction and on the first node connection line (1703), and defining a hole (H4) overlapping the first node connection line (1703).

13. A display apparatus comprising:
a substrate (100);
a first scan line (GWL) on the substrate (100) and extending in a first direction;
a semiconductor layer (1500) on the substrate (100), and comprising a first drain region, a first source region, and a driving active region between the first drain region and the first source region;
a first gate electrode (Ga) on the semiconductor layer (1500) and overlapping the driving active region;
a second gate electrode (Gb) under the semiconductor layer (1500) and overlapping the driving active region; and
a first node connection line (1703) on the first gate electrode (Ga), electrically connected to the first gate electrode (Ga), and extending in a second direction that intersects the first direction,
wherein the second gate electrode (Gb) comprises a protrusion (CEs22p) overlapping an area where the first scan line (GWL) and the first node connection line (1703) intersect each other in a plan view.

14. The display apparatus of claim 13, further comprising a storage capacitor (Cst) comprising a first capacitor electrode (CEs13) integrally provided with the first gate electrode (Ga) and a second capacitor electrode (CEs22) integrally provided with the second gate electrode (Gb).

15. The display apparatus of claim 14, wherein the second capacitor electrode (CEs22) is electrically connected to the first source region.

16. The display apparatus of claim 14 or 15, wherein the storage capacitor (Cst) further comprises a third capacitor electrode (CEs21) on the substrate (100) and a fourth capacitor electrode (CEs12) between the third capacitor electrode (CEs21) and the second capacitor electrode (CEs22),
wherein the first capacitor electrode (CEs13) is electrically connected to the fourth capacitor electrode (CEs12), and
the second capacitor electrode (CEs22) is electrically connected to the third capacitor electrode (CEs21).

17. The display apparatus of claim 16, further comprising a hold capacitor (Chd) comprising a first hold capacitor electrode (CEh21) integrally provided with the third capacitor electrode (CEs21) and a second hold capacitor electrode (CEh11) on the first hold capacitor electrode (CEh21) and electrically connected to a first driving voltage line (PL1).

18. The display apparatus of claim 17, wherein the hold capacitor (Chd) further comprises a third hold capacitor electrode (CEh22) on the second hold capacitor electrode (CEh11) and electrically connected to the first hold capacitor electrode (CEh21) and a fourth hold capacitor electrode (CEh13) on the third hold capacitor electrode (CEh22) and electrically connected to the second hold capacitor electrode (CEh11).

19. The display apparatus of at least one of claims 13 to 18, wherein the semiconductor layer (1500) comprises an oxide semiconductor material.

20. The display apparatus of at least one of claims 13 to 19, further comprising a second driving voltage line (PL2) extending in the second direction and on the first node connection line (1703), and defining a hole (H4) overlapping the first node connection line (1703).
